# EUROPEAN PATENT APPLICATION

(11) **EP 4 737 788 A1**
(43) Date of publication of application: **06.05.2026**
(21) Application number: 24832525.0
(22) Date of filing: 28.06.2024
(51) Int. Cl.: F21K 9/238, F21V 23/00, F21V 29/74, H10H 20/857, F21Y 115/10

(54) **LIGHTING DEVICE AND LAMP**

(30) Priority: 29.06.2023 KR 20230084540; 27.06.2024 KR 20240084177
(71) Applicant: LG INNOTEK CO. LTD, Gangseo-gu Seoul 07796 (KR)
(72) Inventor: LEE, Jung Ho, Seoul 07796 (KR); LEE, Hee Jung, Seoul 07796 (KR); KIM, Won Jin, Seoul 07796 (KR)
(74) Representative: Plasseraud IP
(86) International application number: PCT/KR2024/009147
(87) International publication number: WO 2025/005749

(57) **Abstract**

A lighting device disclosed in an embodiment of the invention includes a support plate; a circuit board disposed on the support plate; a plurality of pads disposed on one side of the circuit board; a light source portion disposed on the support plate and having a light emitting device and a plurality of bonding pads; a plurality of connection members respectively connecting the plurality of pads to the plurality of bonding pads; and a plurality of molding portions covering different regions of at least one of the plurality of connection members, wherein an uppermost end of at least one of the plurality of molding portions based on the upper surface of the circuit board may disposed higher than positions of highest points of the plurality of connection members.

## Description

### [Technical Field]

The embodiment relates to a lighting device and a lamp.

### [Background Art]

Lighting applications include vehicle lights as well as backlights for displays and signs. Light emitting device, such as light emitting diode (LED), have advantages such as low power consumption, semi-permanent life, fast response speed, safety, and environmental friendliness compared to conventional light sources such as fluorescent lamps and incandescent lamps. These light emitting diodes are applied to various display devices, various lighting devices such as indoor or outdoor lights. Recently, as a vehicle light source, a lamp employing a light emitting diode has been proposed. Compared with incandescent lamps, light emitting diodes are advantageous in that power consumption is small. However, since an emission angle of light emitted from the light emitting diode is small, when the light emitting diode is used as a vehicle lamp, there is a demand for increasing the light emitting area of the lamp using the light emitting diode.

### [Disclosure]

### [Technical Problem]

The embodiment of the invention provides a lighting module and a lighting device having a member for fixing at least a portion of a connection member that electrically connects a light source portion and a circuit board. An embodiment of the invention provides a lighting module and lighting device having a member for fixing part or all of a plurality of connection members electrically connecting a light source portion and a circuit board.

An embodiment of the invention provides a lighting module and a lighting device having a member for fixing the position of a portion of one or a plurality of wires on at least one region of an upper surface of a circuit board or an upper surface of a support plate. Embodiments of the invention provide a lighting device and a lamp or automobile lamp having the same.

### [Technical Solution]

The lighting device according to an embodiment of the invention includes a support plate; a circuit board disposed on the support plate; a plurality of pads disposed on one side of the circuit board; a light source portion disposed on the support plate and having a light emitting device and a plurality of bonding pads; a plurality of connection members respectively connecting the plurality of pads to the plurality of bonding pads; and a plurality of molding portions covering different regions of at least one of the plurality of connection members, wherein an uppermost end of at least one of the plurality of molding portions based on the upper surface of the circuit board may disposed higher than positions of highest points of the plurality of connection members.

According to an embodiment of the invention, the plurality of pads includes a first pad and a second pad adjacent to the light source portion, and the plurality of bonding pads includes a first bonding pad and a second bonding pad adjacent to the circuit board, the plurality of connection members includes a first connection member connecting the first pad and the first bonding pad, and a second connection member connecting the second pad and the second bonding pad, and the uppermost end of at least one of the plurality of molding portions may be positioned higher than positions of the highest points of the first and second connection members.

According to an embodiment of the invention, the plurality of molding portions may include a first molding portion disposed on a first end portion of the first connection member connected to the first pad of the light source portion, and the second molding portion disposed on a first end portion of the second connection member connected to the second pad of the light source portion.

According to an embodiment of the invention, the first and second molding portions may be connected to each other in a region between the first pad and the second pad.

According to an embodiment of the invention, regions of the first and second molding portions connected to each other may extend to a region between the light source portion and the circuit board and cover intermediate wire portions of the first and second connection members.

According to an embodiment of the invention, the plurality of molding portions includes a third molding portion disposed on a second end portion of the first connection member connected to the first bonding pad of the circuit board, and a fourth molding portion disposed on the second end portion of the second connection member connected to the second boding pad of the circuit board.

According to an embodiment of the invention, the third molding portion and the fourth molding portion may be connected to each other in a region between the first bonding pad and the second bonding pad of the circuit board. The regions of the third and fourth molding portions connected to each other extend to a region between the light source portion and the circuit board and may cover intermediate wire portions of the first and second connection members. The plurality of molding portions may include a central molding portion disposed on the intermediate connection portions between first and second end portions of the first and second connection members.

According to an embodiment of the invention, the first and second connection members include a first end portion connected to the first and second pads of the light source portion, a second end portion connected to the first and second bonding pads of the circuit board, respectively, and an intermediate wire portion between the first and second end portions, wherein the plurality of molding portions includes a first molding portion covering the first end portion of the first connection member, the intermediate wire portion, and the second end portion, and a second molding portion covering the first end portion, the intermediate wire portion, and the second end portion of the second connection member.

According to an embodiment of the invention, a first connection portion connecting the first and second molding portions to each other on the light source portion may include. A second connection portion connecting the first and second molding portions to each other on the circuit board may include. The support plate may include a concave receiving portion to accommodate the circuit board. According to an embodiment of the invention, each of the plurality of connection members may be a ribbon wire whose width is more than twice a thickness thereof.

A lamp according to an embodiment of the invention includes a lighting device that emits white light; and a light guide module or reflector on the lighting device, wherein the lighting device may include the lighting device disclosed above.

### [Advantageous Effects]

According to an embodiment of the invention, the connection member may be prevented from being deformed and the connection member may be prevented from cracking, thereby improving electrical reliability due to the connection member by supporting and fixing a part or all of the connection members between the light source portion and the circuit board. According to an embodiment of the invention, a part or all of the connection member connecting the light source portion and the circuit board is molded with a molding portion, thereby preventing the flow of the connection member and blocking electrical contact between the connection member and the pad, and suppressing openings or cracks that may occur in the bonding portion between the connection member and the pad.

An Embodiment of the invention can improve the reliability of lighting modules and lighting devices including the same.

### [Description of Drawings]

FIG. 1a is a perspective view of a lighting device according to the invention.
FIG. 1b is a side cross-sectional view of the lighting device of FIG. 1a.
FIG. 2 is an enlarged view showing the light source portion, circuit board, and connection member of FIG. 1a.
FIGS. 3(A)(B) is diagrams showing examples of pulling tests and crack occurrence for the connection member of FIG. 2.
FIG. 4a is a perspective view of a lighting device according to a first embodiment of the invention.
FIG. 4b is an example of a top view of the lighting device of FIG. 4a.
FIG. 4c is a perspective view showing a connection member and a fixing frame of the lighting device of FIG. 4a.
FIG. 5 is an example of a side cross-sectional view of the lighting device of FIG. 4a.
FIG. 6a is a first modified example of a lighting device according to the first embodiment of the invention.
FIG. 6b is a diagram showing the light source portion and fixing frame of FIG. 6a.
FIG. 7 is a second modified example of the lighting device according to the first embodiment of the invention.
FIG. 8 is a diagram showing an example of a fixing frame of the lighting device of FIG. 7.
FIG. 9 is a plan view of a lighting device according to a second embodiment of the invention.
FIG. 10 is a diagram explaining the molding portion, connection member, and pads of the lighting device of FIG. 9.
FIG. 11 is an example of a side cross-sectional view of the lighting device of FIG. 9.
FIG. 12 is a first modified example of the lighting device of FIG. 9.
FIG. 13 is a second modified example of the lighting device of FIG. 9.
FIG. 14 is a third modified example of the lighting device of FIG. 9.
FIG. 15 is a fourth modified example of the lighting device of FIG. 9.
FIG. 16 is an example of a side cross-sectional view of the lighting device of FIG. 15.
FIG. 17 is a fifth modified example of the lighting device of FIG. 9.
FIG. 18 is a sixth modified example of the lighting device of FIG. 9.
FIG. 19 is a seventh modified example of the lighting device of FIG. 9.
FIG. 20 is an eighth modified example of the lighting device of FIG. 9.
FIG. 21 is a ninth modified example of the lighting device of FIG. 9.
FIG. 22a is another example of the lighting device of FIG. 11.
FIG. 22b is another example of the light source portion of the lighting device of FIG. 11.
FIG. 23(A)-(D) is plan views showing examples of the shapes of the molding portion covering the end portion of the connection member on the pad according to the second embodiment of the invention.
FIG. 24 is an example in which a light guide module is combined with a lighting device according to the first embodiment of the invention.
FIG. 25 is an example of a side cross-sectional view of the lighting device of FIG. 24.
FIG. 26 is an example of a side cross-sectional view of a light guide module coupled to the lighting device of FIG. 11.
FIG. 27 is a perspective view of a headlamp to which a lighting device is applied according to an embodiment of the invention.
FIG. 28 is a cross-sectional view of a lighting device with a reflector according to an embodiment of the invention.

### [Best Mode]

Hereinafter, preferred embodiments of the invention will be described in detail with reference to the accompanying drawings. The technical idea of the present invention is not limited to some of the described embodiments, but can be implemented in various different forms, and if it is within the scope of the technical idea of the present invention, one or more of its components may be selectively combined and substituted between embodiments. In addition, terms (including technical and scientific terms) used in the embodiments of the present invention, unless explicitly specifically defined and described, may be interpreted as a meaning that may be generally understood by those skilled in the art to which the present invention belongs, and terms generally used, such as terms defined in the dictionary, may be interpreted in consideration of the context of the related technology.

Terms used in the embodiments of the present invention are for describing the embodiments and are not intended to limit the present invention. In the present specification, the singular form may include a plural form unless specifically described in the phrase, and may include at least one of all combinations that may be combined as A, B, and C when described as "A and/or at least one (or more than one) of B and C". Also, terms such as first, second, A, B, (a), and (b) may be used to describe components of an embodiment of the present invention. These terms are intended only to distinguish the components from other components and are not determined by their nature, sequence, or order. Also, when a component is described as being 'connected', 'coupled' or 'connected' to another component, not only when the component is directly connected, coupled or connected to another component, it may also be 'connected', 'coupled', or 'connected' due to another component between that component and the other component. In addition, when each component is described as being formed or disposed "up (above) or down (bottom)", the up (down) or down (bottom) includes not only when two components are in direct contact with each other, but also when one or more components are formed or disposed between two components. Also, when expressed as "up (above) or down (bottom)", it may include the meaning of not only the upward direction but also the downward direction based on one component.

### <Lighting device>

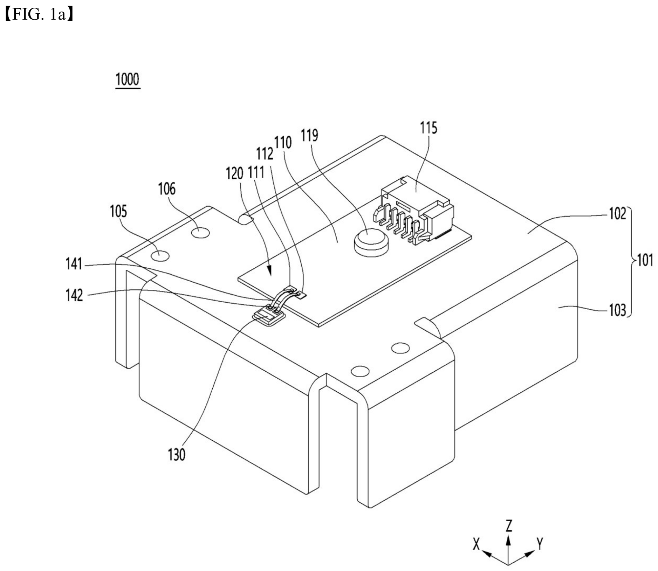

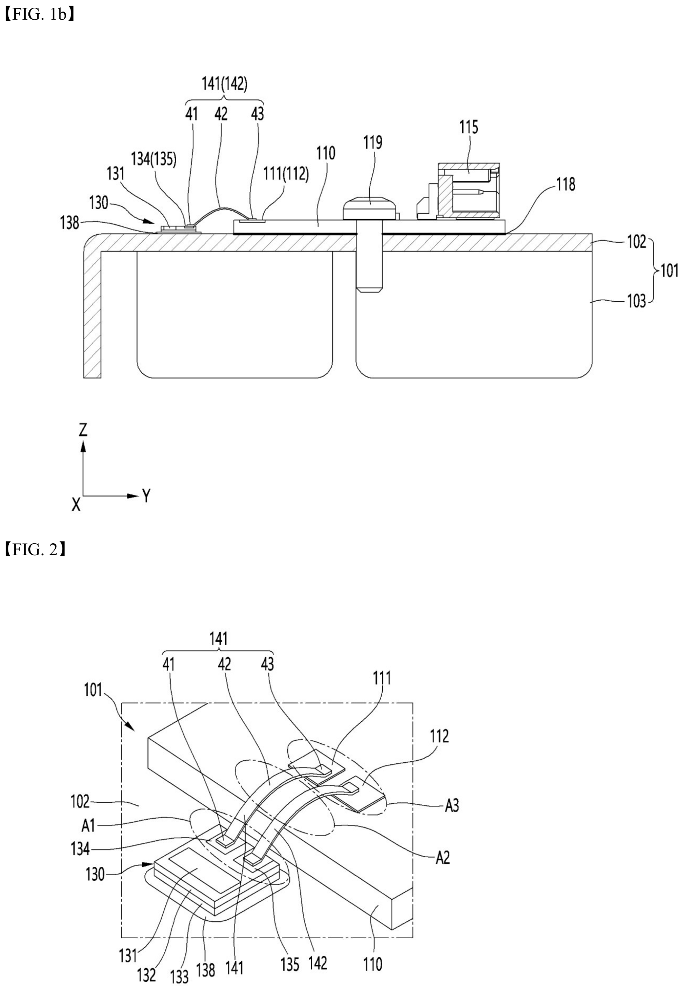

FIG. 1a is a perspective view of a lighting device according to the invention, FIG. 1b is a side cross-sectional view of the lighting device of FIG. 1a, and FIG. 2 is an enlarged view showing the light source portion, circuit board, and connection member of FIG. 1a.

Referring to FIGS. 1a, 1b, and 2, the lighting device 1000 may include a support plate 101, a circuit board 110 disposed on a first region of the support plate 101, and a light source portion 130 disposed on the second region of the support plate 101, and connection members 141 and 142 that electrically connect the light source portion 130 and the circuit board 110. The lighting device 1000 can be applied to various lamp devices that require lighting, such as vehicle lamps, household lighting devices, and industrial lighting devices. For example, when applied to vehicle lamps, it may be applied to head lamps, side mirror lights, side maker lights, a fog lights, tail lights, brake lights, daytime running lights, vehicle interior lights, door scuffs, rear combination lamp, backup lamp, and etc. The lighting device can also be applied to indoor and outdoor advertising devices, display devices, and various electric train fields. The lighting device 1000 may be applied to, for example, the headlamps.

In the lighting device 1000, the light source portion 130 and the circuit board 110 may be spaced apart in any one direction, for example, in a second direction Y among the first and second directions X and Y. The first and second directions X and Y are directions orthogonal to each other, and a third direction Z is a direction orthogonal to the first and second directions X and Y, and the third direction Z may be a vertical direction.

The support plate 101 supports the circuit board 110 and the light source portion 130, and may conduct heat generated from the circuit board 110 and the light source portion 130. The support plate 101 may be a heat dissipation plate. The support plate 101 may be made of metal or may be formed of a laminated structure of a thermally conductive material and a metal layer. The support plate 101 may be formed as a single layer or multiple layers. The thermally conductive material may include a ceramic material, AlN, or an aluminum material having an anodized surface layer. The metal may include at least one of Al, Ni, Mo, Cu, Cu-alloy, Cu-W, Ag, or Au, and may be a single layer or a multilayer of two or more metals. The support plate 101 may further include a heat dissipation fin at the lower portion.

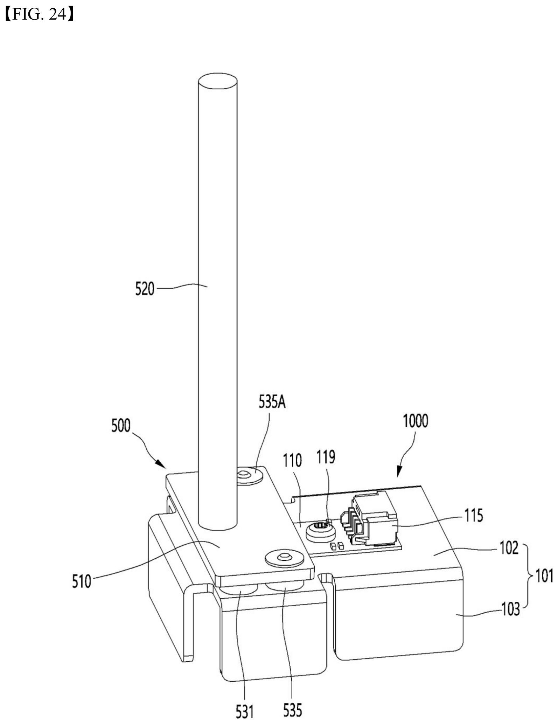

The support plate 101 includes an upper portion 102 and a side portion 103, and the upper surface area of the upper portion 102 may be provided as an area larger than the area of the circuit board 110, for example, 2 times or more, for example, 10 times or more. The side portions 103 may be bent downward from the edge of the upper portion 102, and may be arranged one or more along the outer side of the upper portion 102. Here, the downward direction is a direction opposite to the direction in which the circuit board 110 is disposed on the upper surface of the support plate 101. An empty space may be provided inside the side portion 103 and below the upper portion 102, or a structure such as a heat dissipation fin may be coupled. In the region of the upper portion 102, a plurality of coupling holes 105 and 106 arranged on both sides of the light source portion 130 in the second direction Y may be arranged in the first direction X. An external structure, such as a light guide module 500 (see FIG. 24), may be coupled to the support plate 101 through the coupling holes 105 and 106.

The light source portion 130 is disposed on one region of the upper portion 102 of the support plate 101, and the circuit board 110 is disposed on the other region of the upper portion 102. The light source portion 130 may be disposed at one side of the circuit board 110. The light source portion 130 is disposed on the support plate 101 and may be attached with an adhesive member 138. The adhesive member 138 includes a thermally conductive adhesive member and may be made of an electrically insulating material such as silicon or epoxy. The lower surface of the light source portion 130 may be adhered to the upper surface of the support plate 101, or may be adhered to a region lower than the upper surface of the support plate 101. The adhesive member 138 may adhere the light source portion 130 to the upper portion 102. The adhesive member 138 is disposed on the lower surface of the light source portion 130, protrudes outward from the side surfaces of the light source portion 130, and may be adhered to the lower side of the light source portion 130. The adhesive member 138 may conduct heat generated from the light source portion 130 to the support plate 101.

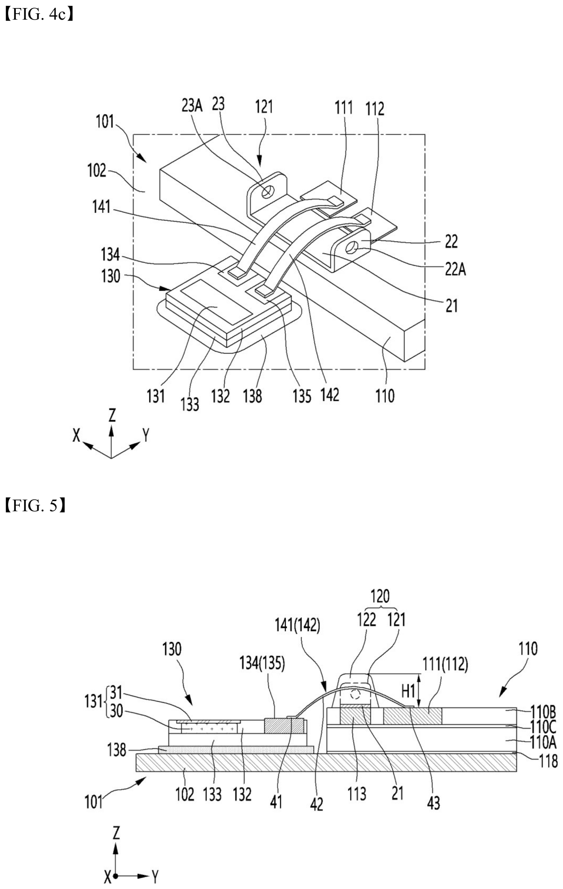

The circuit board 110 may include a resin material or a metal material. The circuit board 110 may be formed of any one of a ceramic-based PCB, a metal core PCB (MCPCB), a flexible PCB (FPCB), and a resin-based PCB. As shown in FIG. 5, the circuit board 110 may include a metal layer 110A at the lower portion, a circuit layer (not shown) having pads 111 and 112 at the upper portion, a protective layer 110B made of an insulating material to protect the circuit layer, and an insulating layer 110C between the metal layer 110A and the pads 111 and 112. The circuit board 110 may be provided as an MCPCB with a metal layer at the lower portion, and may transfer heat to the support plate 101.

Here, the circuit board 110 may be fastened to the upper portion 102 by a fastening means 119, and the fastening means 119 may include one or more screws for fastening and closely contacting the circuit board 110 to the upper portion 102. As another example, the fastening means 119 may include a fastening structure and/or a locking structure. The adhesive film 118 may adhere the circuit board 110 to the upper portion 102 and may be a thermally conductive tape. When the circuit board 110 is fixed by the fastening means 119, the adhesive film 118 may be removed, and the circuit board 110 may be easily separated. The circuit board 110 may be fixed to the upper surface of the support plate 101 using at least one or both of a fastening means 119 or the adhesive film 118.

The pads 111 and 112 of the circuit board 110 may include first and second pads 111 and 112 spaced apart from each other. The first and second pads 111 and 112 may be connected to the connector 115 disposed on the upper surface of the circuit board 110 through the circuit layer of the circuit board 110. The connector 115 may receive driving signal and power from the outside. The pads 111 and 112 may be disposed on one side of the circuit board 110, and the connector 115 may be coupled to the other side of the circuit board 110. The fastening means 119 may be disposed in a region between the pads 111 and 112 and the connector 115. The first and second pads 111 and 112 are disposed adjacent to one side of the circuit board 110 and may be selected from Ti, Ru, Rh, Ir, Mg, Zn, Al, In, Ta, Pd, Co, Ni, Si, Ge, Ag, and Au and optional alloys thereof. The first and second pads 111 and 112 each include a single layer or multiple layers, and in the case of multiple layers, they may include the same or different metals. The circuit board 110 has the protective layer 110B on the metal layer 110A, and the protective layer 110B may protect the pads 111 and 112 and the circuit layer, and may open a boding region or an upper surface region of the pads 111 and 112. The protective layer 110B may be an insulating material, such as a solder resist material, that partially exposes the pads 111 and 112.

The light source portion 130 may be adhered to the upper portion 102 of the support plate 101 with the adhesive member 138. The adhesive member 138 conducts heat generated from the light source portion 130 to the support plate 101. The adhesive member 138 may include a thermally conductive adhesive material having metal powder or inorganic powder in a resin material, such as a thermal interface material (TIM). A side surface of the light source portion 130 may face a portion of a side surface of the circuit board 110. The light source portion 130 and the circuit board 110 may be electrically connected. The light source portion 130 and the circuit board 110 may be connected to at least one connection member 141 and 142. The light source portion 130 may include OLED or LED. The light source portion 130 is driven when power is supplied through the circuit board 110, and emits at least one or more of blue, green, red, and white light. For example, the light source portion 130 may emit white light.

The bonding pads 134 and 135 of the light source portion 130 are disposed adjacent to one side of the circuit board 110. The pads 111 and 112 of the circuit board 110 are disposed adjacent to the other side of the light source portion 130. The bonding pads 134 and 135 of the light source portion 130 may be located close to the circuit board 110 within the region of the light source portion 130.

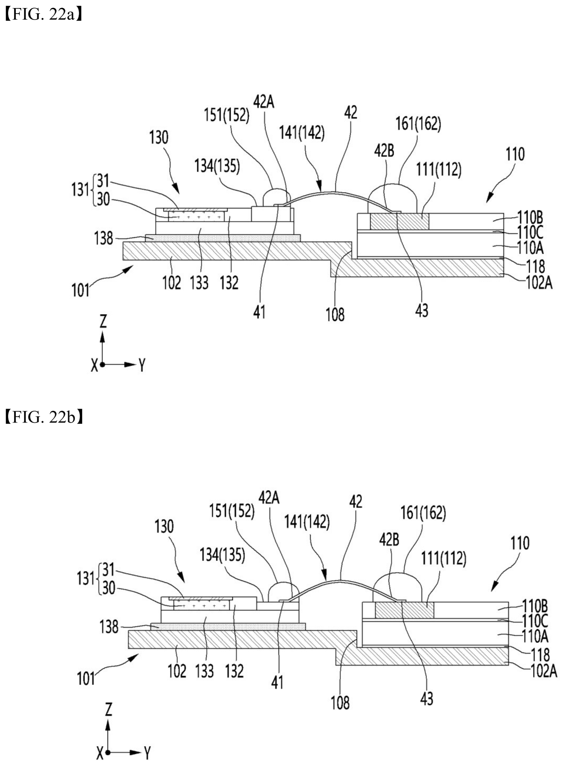

The upper surface of the circuit board 110 may be positioned higher than the upper surface of the light source portion 130 due to the thickness of the circuit board 110. Additionally, the upper surface of the pads 111 and 112 of the circuit board 110 may be positioned higher than the upper surface of the bonding pads 134 and 135 of the light source portion 130. As another example, as shown in FIG. 22a, the lower surface of the circuit board 110 may be placed in the receiving portion 108 lower than a position of the upper surface of the support plate 101 where the light source portion 130 is disposed.

The pad of the circuit board 110 may include first and second pads 111 and 112 spaced apart from each other, and the bonding pad of the light source portion 130 may include first and second bonding pads 134 and 135 spaced apart from each other. The connection members 141 and 142 may include a first connection member 141 and a second connection member 142 spaced apart from each other. The first pad 111 and the first bonding pad 134 are connected to the first connection member 141, and the second connection member 141 may connected to the second pad 112 and the second bonding pad 135. Althogugh each of the pads 111 and 112, the bonding pads 134 and 135, and the connection members 141 and 142 is described as two pieces, but can be changed to one, three, or four pieces depending on the connection type. In addition, the pads 111 and 112, the bonding pads 134 and 135, and the connection members 141 and 142 are described as having the same number, but at least one may have a different number. For example, the lower end of the light source portion 130 may be electrically connected to the support plate 101 through a via structure. In this case, the number of bonding pads 134 and 135, pads 111 and 112, and connection members 141 and 142 may be implemented as one.

The first bonding pad 134 may function as a cathode terminal, and the second bonding pad 135 may function as an anode terminal. The first bonding pad 134 and the second bonding pad 135 may be selected from Ti, Ru, Rh, Ir, Mg, Zn, Al, In, Ta, Pd, Co, Ni, Si, Ge, Ag and Au, and selectively alloys thereof. The first and second bonding pads 134 and 135 may include a single layer or multiple layers, and in the case of multiple layers, they may include the same or different metals.

The first connection member 141 and the second connection member 142 may include an electrically conductive wire, and may include, for example, at least one metal such as Au, Cu, Al, Ag, or a selective alloy thereof. The first connection member 141 and the second connection member 142 are wider wires having a width greater than a thickness thereof, for example, ribbon-shaped wires, and each width W may be 0.4 mm or more, for example, in the range of 0.4 mm to 0.9 mm. The thickness may be 0.15 mm or less, for example, in the range of 0.07 mm to 0.15 mm. The width W of each of the first and second connection members 141 and 142 may be more than twice the thickness of the connection members 141 and 142, for example, more than two times and less than 15 times, and when smaller than the above range, the width W of the connection members 141 and 142 may be tilted downward, bonding strength may decrease, usable current may decrease, and resistance to external force may become weak. Additionally, when the width W of the connection members 141 and 142 is larger than the above range, there is a problem that the size of the bonding pad 134 and 135 or the pad 111 and 112 is increased or material is wasted.

The first connection member 141 and the second connection member 142 include a first end portion 41, a second end portion 43, and an intermediate wire portion 42, and the first end portion 41 is bonded to the first bonding pad 134 and the second bonding pad 135, respectively, and the second end portion 43 is bonded to the first pad 111 and the second pad 112, respectively. The intermediate wire portion 42 is connected between the first end portion 41 and the second end portion 43 and may have a curved shape. The intermediate wire portion 42 may have, for example, a convex curved shape. The intermediate wire portion 42 of the first connection member 141 may be connected between a first end portion 41 bonded to the first bonding pad 134 and a second end portion 43 bonded to the first pad 111. The intermediate wire portion 42 of the second connection member 142 may be connected between a first end portion 41 bonded to the second bonding pad 135 and a second end portion 43 bonded to the second pad 112. The intermediate wire portion 42 may extend from the other side of the light source portion 130 to one side of the circuit board 110. The intermediate wire portion 42 may have a length greater than an interval between the circuit board 110 and the light source portion 130.

The heights of the upper surfaces of the first end portion 41 and the second end portion 43 of the connection members 141 and 142 may be different from each other. For example, the height of the upper surface of the first end portion 41 of the connection members 141 and 142 may be disposed lower than the height of the upper surface of the second end portion 43, and the height of the highest point of the intermediate wire portion 42 may be higher than the height of the upper surface of the first end portion 41 of the connection members 141 and 142, and may be disposed higher than a position of the upper surface of the first end portion 41. The height of the highest point of the intermediate wire portion 42 may be disposed higher than the upper surface of the second end portion 43.

The first connection member 141 and the second connection member 142 may or may not be parallel to each other. When the first connection member 141 and the second connection member 142 are parallel to each other, an interval between the first end portions 41 and an interval between the second end portions 43 of the first connection member 141 and the second connection member 142 may be the same. The interval between the intermediate wire portions 42 of the first and second connection members 141 and 142 may be the same as the interval between the first end portions 41 and the interval between the second end portions 43.

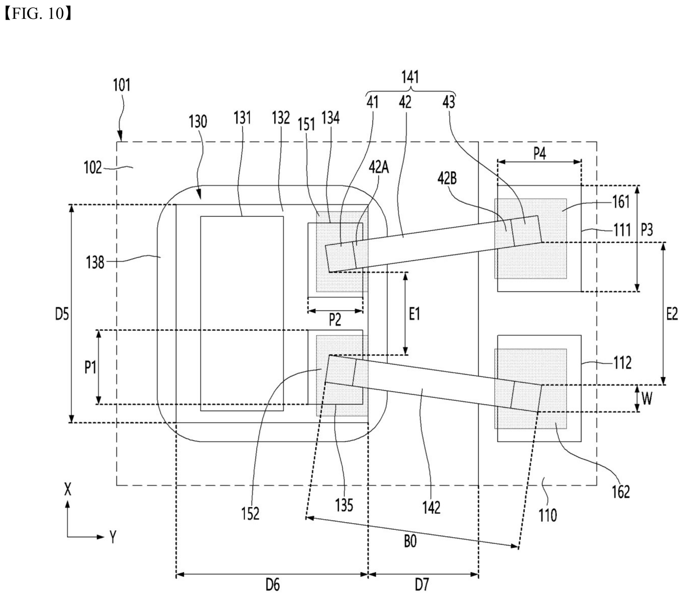

When the first connection member 141 and the second connection member 142 are not parallel to each other, the interval between the first end portions 41 of the first connection member 141 and the second connection member 142 may be different from the interval between the second end portions 43. For example, as shown in FIG. 10, the interval E1 between the first end portions 41 of the first connection member 141 and the second connection member 142 may be smaller than the interval E2 between the second end portions 43. In this case, virtual straight lines extending along the first connection member 141 and the second connection member 142 may intersect each other.

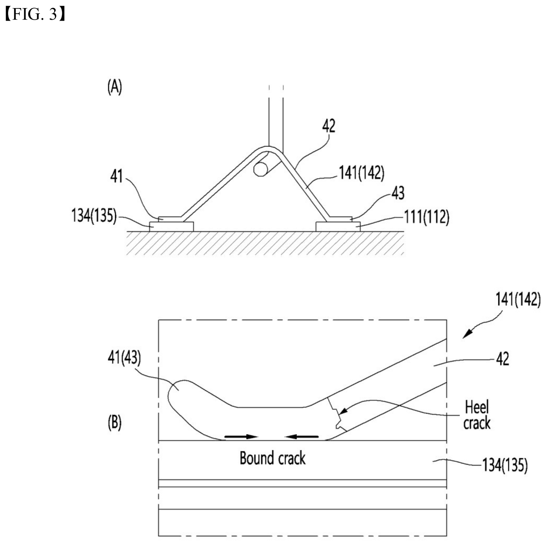

AS shown in FIGS. 2 and 3, a height difference between the first connection member 141 and the second connection member 142 based on the upper surface of the support plate 101 occurs between the first end portion 41 and the second end portion 43 based on the upper surface of the support plate 101. When the first and second end portions 41 and 43 are bonded to pads 111 and 112 and bonding pads 134 and 135, respectively, a bonding failure or an open failure may occur at each of the end portions 41 and 43 due to a height difference between the first end portions 41 and the second end portions 43 of the first and second connection members 141 and 142. The bonding may be performed through an ultrasonic soldering process, and heat of 200 degrees or more is generated.

In addition, as shown in (A) of FIG. 3, when a wire pull off test is performed after bonding of the connection members 141 and 142, an open failure may occur due to a heel crack or the like at a connection part or/and a bent part between the second end 43 and the intermediate wire portion 42 of the connection members 141 and 142, or a bound crack may occur at a boundary between the first end portion 41 or the second end portion 43 and the pads 111 and 112 or the bonding pads 134 and 135. In order to prevent the opening failure of the connection members 141 and 142, it is designed in consideration of the linear distance between the first end portion 41 and the second end portion 43, the inclination angle extending from the first end portion 41 to the intermediate wire portion 42, and the inclination angle extending from the second end portion 43 to the intermediate wire portion 42, etc. However, when there is a large temperature change or an external impact, cracks may occur at the boundary between the intermediate wire portion 42 and the first and second end portions 41 and 43 of the connection members 141 and 142. That is, it may be seen that the joint at which the wire is bent during soldering is the most vulnerable to external force and the environment.

An embodiment of the invention may provide a member having a molding portion of a resin material on at least one of a region A1 of the first end portion 41, a region A2 of the intermediate wire portion 42, or a region A3 of the second end portion 43 of the connection members 141 and 142. The member having the molding part may mold at least one or both of the region A1 of the first end portion 41, the region A2 of the intermediate wire portion 42, or the region A3 of the second end portion 43 of the connection members 141 and 142, and fix at least a portion of the connection members 141 and 142 from an external impact, or suppress moisture penetration into the regions A1 and A3 of the first and second end portions 41 and 42 to prevent metal oxidation. The molding portion may mold at least one or two regions of the first end portion 41, the intermediate wire portion 42, and the second end portion 43 of the first connection member 141. The molding portion may mold at least one or two regions of the first end portion 41, the intermediate wire portion 42, and the second end portion 43 of the second connection member 142. The member having the molding portion may be made of a material with a low elastic modulus. In this case, the stress transmitted to the wire can be reduced and the joint strength of the bonding portion can be increased. When evaluating the wire bonding strength (admitted strength) through the full test, the standard bonding strength is about 135 gf per bonding area, and when molding into a member having the molding portion, it is more than twice the standard bonding strength. The molding portion or the member having the molding portion will be described in detail in embodiments described later.

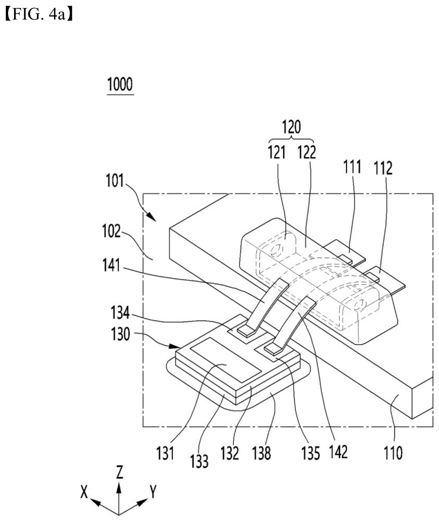

FIGS. 4a to 4c and FIG. 5 are examples of lighting devices according to the first embodiment of the invention.

As shown in FIGS. 4a to 4c and 5, the lighting device 1000 includes a support plate 101, a circuit board 110 and a light source portion 130 on the support plate 101, a connection member 141 and 142 connected between the light source portion 130 and the circuit board 110, and a fixing member 120 having a molding portion 122 covering a portion of the connection member 141 and 142.

The light source portion 130 includes a support member 133 and a light emitting device 131 disposed on the support member 133, and the light emitting device 131 may include, for example, one or more light emitting devices. The light source portion 130 may include a resin member 132, and the resin member 132 may be disposed around the light emitting device 131.

The support member 133 may include a ceramic substrate or a semiconductor substrate. The support member 133 may be provided as a ceramic layer or a metal layer. The support member 133 may conduct heat generated from the light emitting device 131 through the support plate 101. The support member 133 may be attached to the support plate 101 using the adhesive member 138. The adhesive member 138 may be in contact along the lower surface and sides of the support member 133. Since the adhesive member 138 is in contact with the lower surface and sides of the support member 133, heat generated through the support member 133 can be conducted to the support plate 101.

The support member 133 may support the light emitting device 131 and may include a conductive pattern electrically connected to the light emitting device 131. The light source portion 130 may have the light emitting device 131 on one side and the bonding pads 134 and 135 on the other side. The light emitting device 131 may be disposed on one side of the support member 131 and the bonding pad 134 and 135 may be disposed on the other side of the support member 131. The height of the upper surface of the bonding pads 134 and 135 may be higher than the height of the upper surface of the resin member 132 or may be arranged at the same height as the height of the upper surface of the resin member 132. A protection device (not shown) may be disposed on the support member 133 to protect the light emitting devices 131, and the protection device may be implemented as a thyristor, Zener diode, or transient voltage suppression (TVS), and may protect the light emitting device 131 from ESD (electro static discharge).

The light emitting device 131 may include at least one of blue, green, or red LED chips. The light emitting device 131 may be provided as one of vertical type, horizontal type, or flip type chips. The light emitting device 131 may include a package having an LED chip and a molding member made of a transparent resin material disposed on the LED chip. The resin member 132 may be formed of a single or multi-layer material containing silicon or epoxy. The resin member 132 may further include a convex lens (not shown) at the upper portion. The light emitting device 131 may include at least one light emitting chip 30 disposed on the support member 133 and a wavelength conversion layer 31 disposed on the at least one light emitting chip 30. One or more light emitting chip 30 may be disposed, and may include a plurality of semiconductor layers made of a compound semiconductor of group II and group VI elements or/and a compound semiconductor of group III and group V elements, and at least one or all of the plurality of semiconductor layers may include a compound semiconductor of the following series: AlInGaN, InGaN, AlGaN, GaN, GaAs, InGaP, AllnGaP, InP, and InGaAs. The wavelength conversion layer 31 is disposed on the light emitting chip 30 and may cover the entire upper surface of the light emitting chip 30. The wavelength conversion layer 31 converts some of the light emitted from the light emitting chip 30 to the wavelength. The wavelength conversion layer 31 may be in contact with the upper surface of the light emitting chip 30 and a portion of the resin member 132. The wavelength conversion layer 31 may include at least one or two of yellow phosphor, green phosphor, blue phosphor, and red phosphor. The light emitting device 131 may emit white light. The light emitting device 131 may emit light with the highest luminous intensity in a direction perpendicular to the upper surface of the light emitting device 131. As another example, the light emitting device 131 may have LED chips of different wavelengths, and in this case, the wavelength conversion layer may be removed. The LED chips of different wavelengths may include red LED chips, green LED chips, and blue LED chips.

The light emitting device 131 may be disposed on an upper portion of one region of the support member 133, and the bonding pads 134 and 135 may be disposed on an upper portion of the other region of the support member 133. The bonding pads 134 and 135 may include a first bonding pad 134 connected to the cathode of the light emitting device 131 and a second bonding pad 135 connected to the anode of the light emitting device 131. The support member 133 has an electrode pattern on which the first and second bonding pads 134 and 135 are disposed, and the electrode pattern may electrically connect the light emitting device 131 and the first and second bonding pads 134 and 135. The first and second bonding pads 134 and 135 may be exposed on the upper surface of the other region of the support member 133. The distance between the light source portion 130 and the circuit board 110 may be 3 mm or more, for example, in the range of 3 mm to 10 mm or 3 mm to 8 mm. If the distance is smaller than the range, the buffer space due to the difference in thermal expansion between the light source portion 130 and the circuit board 110 is reduced, and when the light source portion 130 moves, the electrical reliability of the first and second connection member 141 and 142 may be reduced. If the distance between the light source portion 130 and the circuit board 110 is greater than the above range, the length or material of the first and second connection members 141 and 142 increase.

The fixing member 120 may be disposed on either or both the circuit board 110 and the support plate 101. The fixing member 120 includes the molding portion 122, and the molding portion 122 may mold at least one region or different regions of each of the connection members 141 and 142. The fixing member 120 may include a fixing frame 121 for fixing the molding portion 122. The fixing frame 121 may be disposed at a lower portion of the fixing member 120, and the molding portion 122 may be disposed on the upper portion of the fixing member 120. The fixing frame 121 may be disposed on at least one or both of the circuit board 110 and the support plate 101. The fixing frame 121 may be glued or bonded to the circuit board 110 or/and the support plate 101. The fixing frame 121 may be fixed on the circuit board 110 or/and the support plate 101. The fixing frame 121 may fix the position of the molding portion 122 below the molding portion 122. The fixing frame 121 may be in contact with at least a portion of the molding portion 122, may be coupled to at least one of the inside or outside of the molding portion 122, or may be coupled to a different region of the molding portion 122. As another example, the fixing member 120 may be composed of a molding portion 122 without a fixing frame.

The molding portion 122 may contact at least one or both of the first and second connection members 141 and 142 and may fix the position of at least a portion of each of the first and second connection members 141 and 142. The molding portion 122 may fix at least one intermediate wire portion 42 of the first and second connection members 141 and 142 on the circuit board 110. Since the molding portion 122 surrounds and supports the circumference of the intermediate wire portion 42 of the first and second connection members 141 and 142, the position of the intermediate wire portion 42 may be fixed.

The fixing frame 121 may be disposed in a region that overlaps the circuit board 110 in the vertical direction. The molding portion 122 molds and supports a region of the intermediate wire portion 42 of the first and second connection members 141 and 142 that overlaps the circuit board 110 in the vertical direction. The molding portion 122 molds and supports a region vertically overlapping the region between one side of the circuit board 110 and the pads 111 and 112 among the regions of the intermediate wire portions 42 of the first and second connection members 141 and 142.

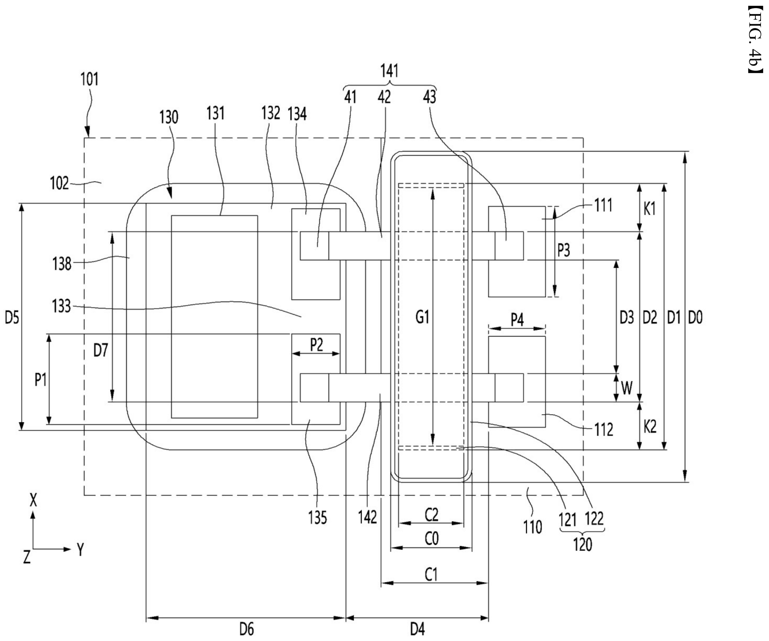

The fixing frame 121 may be glued or bonded to the circuit board 110. The fixing frame 121 may be bonded to the sub pad 113 disposed within the circuit board 110 with a bonding member (not shown). The fixing frame 121 may include a bottom portion 21 bonded to the sub pad 113, and support portions 22 and 23 bent from one or both ends of the bottom portion 21. The support portions 22 and 23 may be bent in the third direction Z of the circuit board 110 from one or both ends of the bottom portion 21. The bent portion between the bottom portion 21 and the support portions 22 and 23 may include a curved surface. The bottom portion 21 may be disposed between the pads 111 and 112 and one side of the circuit board 110. As shown in FIG. 4b, the separation distance G1 between the support portions 22 and 23 on both sides of the fixing frame 121 may be greater than the maximum length in the first direction X of the region having the pads 111 and 112. The separation distance G1 between the support portions 22 and 23 in the first direction X may be greater than the maximum length D2 of the region having the connection members 141 and 142.

The sub pad 113 may be formed of the same material as the pads 111 and 112. The fixing frame 121 may be made of a metal material, for example, at least one of Cu, Ti, Al, Pd, Co, Ni, Ag, and Au, or an alloy of two or more of the above metals. The fixing frame 121 may be formed as a single layer or multiple layers using the metal. The number of fixing frames 121 and the number of molding portions 122 may be the same. As another example, the number of molding portions 122 may be greater than the number of fixing frames 121, and in this case, the molding portions 122 may be formed in different regions of the fixing frames 121. As another example, the fixing frame 121 may be made of a non-metallic material.

The molding portion 122 is disposed on the fixing frame 121, and the fixing frame 121 may be disposed within a region of the molding portion 122. That is, the fixing frame 121 may be attached to the upper surface of the circuit board 110 and embedded in the lower portion of the molding portion 122. The molding portion 122 may be disposed in a region between the surface of the bottom portion 21 of the fixing frame 121 and the support portions 22 and 23. The molding portion 122 may be disposed above and outside the support portions 22 and 23. The molding portion 122 may be disposed around the support portions 22 and 23. Accordingly, the molding portion 122 can cover the entire upper surface of the fixing frame 121. Additionally, the molding portion 122 may contact at least one or both of the surface of the fixing frame 121 and the upper surface of the circuit board 110.

The molding portion 122 may be disposed on a region between the first end portion 41 and the second end portion 43 of the first connection member 141. The molding portion 122 may be disposed on a region between the first end portion 41 and the second end portion 43 of the second connection member 142. The molding portion 122 covers a region having the highest point of the first connection member 141 and the height of the uppermost end of the molding portion 122 may be located higher than the highest point of the first connection member 141. The molding portion 122 covers a region having the highest point of the second connection member 142 and the height of the uppermost end of the molding portion 122 may be located higher than the highest point of the second connection member 142. That is, the molding portion 122 may cover the region having the highest points of the intermediate wire portions 42 of the first and second connection members 141 and 142, and may cover the region of the the intermediate wire portion 42 overlapped direction perpendicular to the circuit board 110 on the circuit board 110.

The molding portion 122 may include a resin material such as silicone or epoxy, acrylate, urethane, polyolefin, UV resin, or an insulating material, or may be an optional mixture thereof. The molding portion 122 may be dispensed on the fixing frame 121 and then cured using a method selected from high temperature curing, room temperature curing, or UV curing. The molding portion 122 may be an adhesive member or an insulating member attached to the connection members 141 and 142. The molding portion 122 may include a diffusion agent or a reflective material therein. The molding portion 122 has a plurality of side surfaces and an upper surface, and an edge portion between the plurality of side surfaces may include a curved surface or an angled surface, for example, has a curved surface, and an edge portion between each side surface and the upper surface may have a curved or angled surface, such as a curved surface.

The support portions 22 and 23 of the fixing frame 121 are arranged as first and second support portions 22 and 23 disposed on both sides of the bottom portion 21 in the first direction X, or may be arranged as a first support portion 22 or a second support portion 23 disposed at one end or the other end of the first direction X of the bottom portion 21. Corner portions of the upper surfaces of the support portions 22 and 23 in the second direction Y may be curved or angled surface. The support portions 22 and 23 may protrude toward an outer region of the intermediate wire portion 42 of each of the first and second connection members 141 and 142. The fixing frame 121 may further include a support portion (not shown) protruding into the region between the first and second connection members 141 and 142. The support portions 22 and 23 are one or more, protrude from the fixing frame 121 toward the upper surface of the molding portion 122, and may be disposed in a region that does not overlap in a direction perpendicular to the upper surface of the support plate 101 and the intermediate wire portion 42 of the first and second connection members 141 and 142.

The fixing member 120 and the first and second connection members 141 and 142 may overlap in a direction perpendicular to the upper surface of the support plate 101 (i.e., Z direction). The fixing member 120 and parts of the first and second connection members 141 and 142 may overlap in a direction perpendicular to the upper surface of the support plate 101. Parts of the first and second connection members 141 and 142, the fixing member 120, and the circuit board 110 may overlap in a direction perpendicular to the upper surface of the support plate 101. The molding portion 122 of the fixing member 120 and parts of the first and second connection members 141 and 142 may overlap the upper surface of the support plate 101 in a vertical direction.

The fixing member 120 may separate the position of the intermediate wire portion 42 of the first and second connection members 141 and 142 from the upper surface of the circuit board 110. The molding portion 122 may separate the intermediate wire portion 42 of the first and second connection members 141 and 142 from the upper surface of the fixing frame 121. The highest point region of the intermediate wire portion 42 may be disposed between the upper surface of the circuit board 110 and the upper surface of the molding portion 122. The highest point region of the intermediate wire portion 42 may be disposed between the lower surface of the molding portion 122 and the upper surface of the molding portion 122. The highest point region of the intermediate wire portion 42 may be disposed between the fixing frame 121 and the upper surface of the molding portion 122.

The height H1 of the upper end of the molding portion 122 based on the upper surface of the circuit board 110 may be higher than the height of the highest points of the connection members 141 and 142. Based on the upper surface of the circuit board 110, the highest points of the first and second connection members 141 and 142 may be located between the upper end of the molding portion 122 and the fixing frame 121. Based on the upper surface of the circuit board 110, the height of the highest points of the first and second connection members 141 and 142 may be higher than that of the bottom portion 21 of the fixing frame 121 and lower than the height of the upper ends of the support portions 22 and 23. As another example, the positions of the highest points of the first and second connection members 141 and 142 based on the upper surface of the circuit board 110 may be higher than that of the upper ends of the support portions 22 and 23 of the fixing frame 121.

At least one or both of the support portions 22 and 23 of the fixing frame 121 may include holes 22A and 23A on the inside thereof. The molding portion 122 may be coupled to the holes 22A and 23A of the support portions 22 and 23. Since the molding portion 122 is coupled to the holes 22A and 23A of the support portions 22 and 23, the support portions 22 and 23 may prevent the molding portion 122 being break away or separated from the fixing frame 121. The holes 22A and 23A may have a circular or polygonal shape and may be arranged one or more in each support portion 22 and 23. As another example, the fixing frame 121 may include at least one of a groove, a locking protrusion, or a locking jaw for fixing the molding portion 122.

As shown in FIG. 4b, a length D0 of the fixing member 120 is a length in the first direction X perpendicular to the extending direction of the connection members 141 and 142, and is the maximum length in the first direction X of the molding portion 122. The length D0 of the fixing member 120 in the first direction X may be greater than the maximum length in the first direction X of a region where the first and second pads 112 and 111 are disposed. The length D0 of the fixing member 120 may be greater than the minimum separation distance D3 between the first and second connection members 141 and 142 in the first direction X and may be larger than the maximum length D2 of the region having the the connection members 141 and 142. The length D1 of the fixing frame 121 in the first direction X may be greater than the maximum length of the area having the first bonding pad 134 and the second bonding pad 135 in the first direction X. The length D1 of the fixing frame 121 in the first direction X may be greater than the length D5 of the light source portion 130.

The length D0 of the fixing member 120 in the first direction X varies depending on the extension direction of the connection members 141 and 142, for example, may be a length that can cover the middle region of two connection members 141 and 142 spaced apart in the first direction X, or may be 1.5 times or more larger than a length (e.g., maximum separation distance) of the region where the two connection members 141 and 142 are disposed. The length D1 of the fixing frame 121 in the first direction X may be greater than the maximum length of the region having the first pad 111 and the second pad 112 in the first direction X.

Both side surfaces of the fixing member 120 in the first direction X are disposed further outward in the first direction X than the outer sides of each bonding pad 134 and 135 in the first direction X, and may be disposed further outside of each pad 111 and 112 in the first direction X. The fixing member 120 may prevent a flow of the first and second connection members 141 and 142 in a vertical direction and a flow in a horizontal direction with respect to the upper surface of the circuit board 110, thereby preventing a short circuit problem due to contact between the connection members 141 and 142 and the upper portion 102 of the support plate 101.

A bottom width C2 of the fixing frame 121 in the second direction Y may be equal to or smaller than the upper surface width of the molding portion 122 and may be smaller than a bottom width C0 of the fixing member 120. Since the bottom width C0 of the fixing member 120 is disposed to be larger than the bottom width C2 of the fixing frame 121, the molding portion 122 can seal the fixing frame 121, and increase an adhesive area between the molding portion 122 and the circuit board 110.

The bottom width C0 of the fixing member 120 in the second direction Y is a bottom width of the molding portion 122, and may be smaller than a distance C1 between the pads 111 and 112 of the circuit board 110 and one side of the circuit board 110. Accordingly, the fixing member 120 may be disposed between the pads 111 and 112 and one side of the circuit board 110 on the upper surface of the circuit board 110. The fixing member 120 may be disposed between the light source portion 130 and the pads 111 and 112. The distance D4 between the light source portion 130 and the pads 111 and 112 of the circuit board 110 may be greater than 1 time the bottom width C0 of the fixing member 120, for example, greater than 1 time and less than or equal to 3 times. Here, a width P2 of the first and second bonding pads 134 and 135 in the second direction Y may be 0.7 mm or more, for example, in the range of 0.7 mm to 1 mm, and the length P1 in the first direction X may be 1 mm or more, for example, in the range of 1 mm to 1.4 mm. In the second direction Y, a width P4 of the first and second pads 111 and 112 may be disposed in a range of 80% to 120% of the width P2 of the first and second bonding pads 134 and 135, respectively. The length P3 of the first and second pads 111 and 112 in the first direction may be disposed in a range of 80% to 120% of the width P2 of the first and second bonding pads 134 and 135, respectively.

Both ends of the fixing frame 121 in the first direction X may further protrude by predetermined distances K1 and K2 from the outside of each of the first and second connection members 141 and 142, toward the outside of each of the first and second bonding pads 134 and 135, for example, the distances K1 and K2 may range from 0.2 mm or more, for example, from 0.2 mm to 0.8 mm. The distances K1 and K2 may be spaced apart from each other to prevent a problem in which the intermediate wire portions 42 of the connection members 141 and 142 move in both sides in the first direction X.

The fixing member 120 fixes and supports the connection members 141 and 142 on the circuit board 110, thereby preventing movement of the connection members 141 and 142, and the connection members 141 and 142 and the support plate 101, and preventing a short circuit problem between the connection members 141 and 142 and the support plate 101. Since each of the support portions 22 and 23 of the fixing frame 121 is coupled to the inside of the molding portion 122, expansion or contraction of the molding portion 122 in the first direction X may be suppressed. In addition, by protecting the space between both ends of the connection members 141 and 142 with the molding portion 122 by external force, deformation of the connection members 141 and 142 can be reduced and external exposure can be reduced, and the short circuit problems the intermediate wire portion 42 may be prevented.

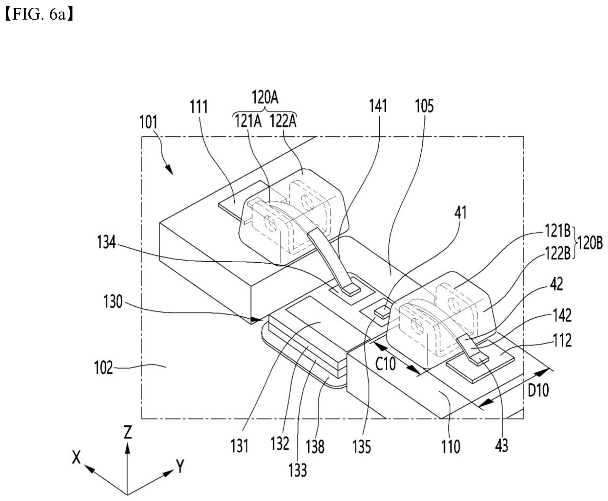

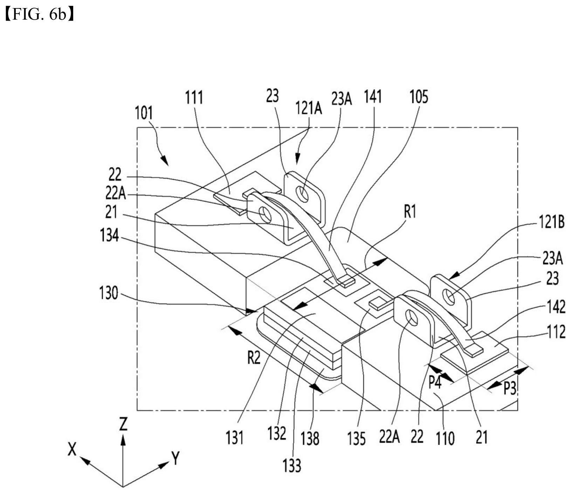

FIGS. 6a and 6b are a first modified example of a lighting device according to a first embodiment of the invention.

Referring to FIGS. 6a and 6b, the lighting device includes a recess 105 in which the light source portion 130 is accommodated, and the recess 105 may be concave from one side surface toward the other side surface of the circuit board 110. The length R2 of the recess 105 in the first direction X may be greater than the length D5 of the light source portion 130 in the first direction (see FIG. 4b), for example, the length R2 may be more than 1 time but less than 2 times the length D5. The length R1 of the recess 105 in the second direction Y may be greater than the length D6 of the light source portion 130 in the second direction (see FIG. 4b), for example, the length R1 may be more than 0.5 times but less than 2 times the length D6. That is, the light source portion 130 may be partially or entirely accommodated in the recess 105 in the first direction X. Accordingly, a portion of the light source portion 130 may be disposed further inside than one side of the circuit board 110.

A first pad 111 and a second pad 112 may be disposed on both sides of the recess 105 of the circuit board 110 in the first direction X. That is, the first and second pads 111 and 112 may be spaced apart from each other in the first direction X by an interval greater than the length R2 of the recess 105. The top view shape of the recess 105 may have a shape corresponding to the top view shape of the light source portion 130, and may be, for example, a square shape or a square shape with curved corners. Additionally, the top view shape of the recess 105 may be a shape in which at least a portion of the side surface of the recess 105 has a curved surface. When the light source portion 130 is accommodated in the recess 105, the adhesive member 138 that adheres the light source portion 130 to the upper portion 102 may be disposed in the recess 105. The adhesive member 138 may be spaced apart from the inner surface of the recess 105 or may be in contact with the inner surface of the recess 105. The light source portion 130 may be accommodated within the recess 105 and stably disposed.

The fixing members 120A and 120B may include first and second fixing members 120A and 120B disposed on both sides of the light source portion 130 and spaced apart in the first direction X. The first fixing member 120A and the second fixing member 120B may correspond to each other on both sides of the recess 105 in the first direction X. For example, the first and second fixing members 120A and 120B may be disposed facing each other on both sides of the recess 105 in the first direction X.

The first bonding pad 134 of the light source portion 130 and the first pad 111 of the circuit board 110 are connected by the first connection member 141, and the second bonding pad 135 of the light source portion 130 and the second pad 112 of the circuit board 110 are connected by the second connection member 142. The first connection member 141 and the second connection member 142 may extend long in the first direction X.

Each of the first and second fixing members 120A and 120B includes fixing frames 121A and 121B and molding portions 122A and 122B. The first fixing member 120A may be disposed on a region between the recess 105 and the first pad 111. The second fixing member 120B may be disposed on a region between the recess 105 and the second pad 112. The interval between the first and second molding portions 122A and 122B may be greater than or equal to the length R2 of the recess 105 in the first direction X. As another example, each of the first and second fixing members 120A and 120B may be composed of molding portions 122A and 122B without fixing frames 121A and 121B.

The first molding portion 122A of the first fixing member 120A fixes a portion of the first connection member 141 on the circuit board 110, and the first molding portion 122A of the second fixing member 120B fixes a portion of the second connection member 142 on the circuit board 110. The first molding portion 122A may be disposed on a region of the upper surface of the circuit board 110 that vertically overlaps the intermediate wire portion 42 of the first connection member 141. The second molding portion 122B may be disposed on a region of the upper surface of the circuit board 110 that vertically overlaps the intermediate wire portion 42 of the second connection member 142. Parts of the first and second connection members 141 and 142 are molded into the molding portions 122A and 122B of the first and second fixing members 120A and 120B, and the positions of the intermediate wire portions 42 of the first and second connection members 141 and 142 may be fixed by the molding portions 122A and 122B. Each of the fixing frames 121A and 121B may be attached to the circuit board 110 with adhesive or may be attached to a sub pad 113 (see FIG. 5).

The position of the highest point of the first connection member 141 based on the upper surface of the circuit board 110 may be lower than the highest point of the first fixing member 120A or the highest point of the first molding portion 122A. The position of the highest point of the second connection member 142 based on the upper surface of the circuit board 110 may be lower than the high point of the second fixing member 120B or the highest point of the second molding portion 122B. The length D10 of each of the first and second fixing members 120A and 120B in the first direction X may be greater than the length C10 in the second direction Y. The length D10 of the first and second fixing members 120A and 120B in the second direction Y may be greater than the length P3 of the first and second pads 111 and 112 in the second direction Y, and the length C10 of the first and second fixing members 120A and 120B in the first direction X may be greater than the length P4 of the first and second pads 111 and 112 in the first direction X. Here, the lengths P3 and P4 of the first and second pads 111 and 112 in the first and second directions X and Y may vary depending on the direction in which the connection members 141 and 142 extend.

The first and second fixing members 120A and 120B may include a bottom portion 21 and support portions 22 and 23 bent on one or both sides of the bottom portion 21 in the second direction Y in FIG. 6(b). The molding portions 122A and 122B may cover the bottom portion 21 and the support portions 22 and 23. The height of the highest points of the first and second connection members 141 and 142 based on the upper surface of the circuit board 110 may be higher than the bottom portion 21 of the fixing frame 121A and lower than the height of the upper ends of the support portions 22 and 23. As another example, the height of the highest points of the first and second connection members 141 and 142 based on the upper surface of the circuit board 110 may be higher than the height of the upper ends of the support portions 22 and 23 of the fixing frame 121A and may be lower than the high point height of the molding portion 122A and 122B. The length D10 of each of the molding portions 122A and 122B or the fixing members 120A and 120B in the second direction Y may be smaller than the length R1 of the recess 105 in the second direction Y. The interval in the first direction X between the first and second fixing members 120A and 120B is greater than or equal to the length R2 of the recess 105 in the first direction X, and interference with light emitted from the light source portion 130 may be reduced.

The molding portions 122A and 122B may be formed within the holes 22A and 23A of the support portions 22 and 23. That is, the molding portions 122A and 122B extend inside the holes 22A and 23A of the support portions 22 and 23, and extend to the inside and outside of the support portions 22 and 23, and may be attached and fixed to the the fixing frames 121A and 121B. For the beam angle of light emitted from the light emitting device 131, the inner surfaces of the molding portions 122A and 122B are inclined with respect to the upper surface of the circuit board 110, or a region between the first and second fixing members 120A and 120B and a region of between the molding portions 122A and 122B may not overlap with the upper region of the light emitting device 131 in the first direction X. The region between the first and second fixing members 120A and 120B and the molding portions 122A and 122B may not overlap with the upper region of the light emitting device 131 in the second direction Y.

The length D10 of each of the first and second fixing members 120A and 120B in the second direction Y varies depending on the extension direction of the first and second connection members 141 and 142, for example, may be a length capable of covering a part of each of the connection member 141 and 142, or may be at least two times larger than the width W (in FIG. 4b) of the one connection member 141 and 142, for example, at least three times larger. The first and second fixing members 120A and 120B respectively fix and support portions of the first and second connection members 141 and 142, for example, a part of the intermediate wire portion 42, on the circuit board 110, thereby preventing movement of each of the first and second connection members 141 and 142 and prevent a short circuit between the first and second connection members 141 and 142 and the support plate 101.

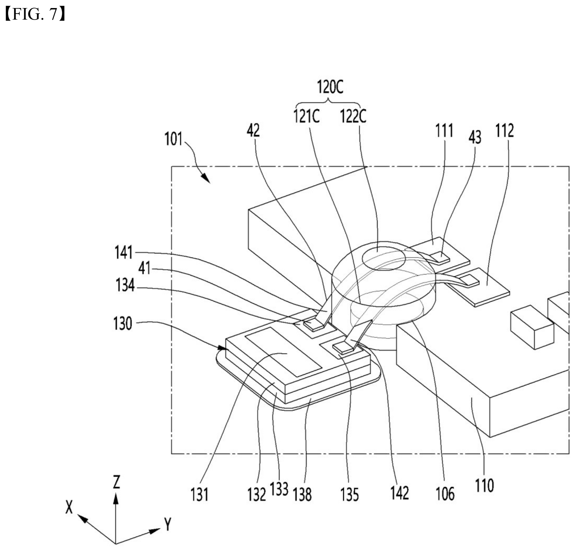

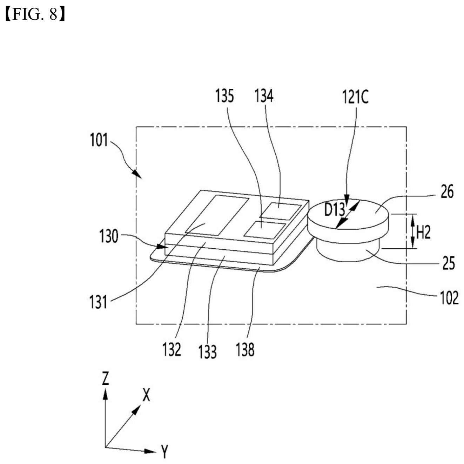

FIGS. 7 and 8 show a second modified example of the lighting device according to the first embodiment of the invention.

Referring to FIGS. 7 and 8, the circuit board 110 may include a concave recess 106 on one side. A top view shape of the recess 106 may have a circular, oval, or semicircular. A portion or lower portion of the fixing member 120C may be disposed in the recess 106. Since the fixing member 120C is disposed within the recess 106, the interval between the light source portion 130 and the circuit board 110 can be reduced.

The fixing member 120C includes a fixing frame 121C and a molding portion 122C, and the fixing frame 121C may be adhered to the upper surface of the support plate 101 with adhesive or bonded by a bonding member (not shown). The fixing frame 121C may be formed integrally with the support plate 101. The fixing frame 121C is made of metal and can be bonded to the support plate 101. The fixing frame 121C may include a pillar-shaped lower frame 25 and a plate-shaped upper frame 26, wherein the pillar shape is a circular pillar or a polygonal pillar, and a top view shape of the plate shape may be a circular or a polygonal shape. The upper frame 26 has a diameter D13 or width larger than the diameter or width of the lower frame 25, and may have a diameter D13 or width greater than the length D2 (see FIG. 4b) of the region in the first direction X where the connection members 141 and 142 are placed. The fixing member 120C may be composed of a molding portion 122C without a fixing frame 121C. That is, the diameter D13 is longer than the length of the intermediate wire portion 42 of the first and second connection members 141 and 142 and the overlapping region in the vertical direction with respect to the upper surface of the circuit board 110, or may have the length greater than the length between both ends of the intermediate wire portion 42 of the connection members 141 and 142 in the first direction X.

Since the molding portion 122C is disposed on the periphery of the lower frame 25 and a surface and periphery of the upper frame 26 of the fixing member 120C, and is caught in a locking structure between the lower frame 25 and the upper frame 26, movement or separation by the structure or shape of the fixing frame 121C may be prevented. The lower portion of the molding portion 122C may be shaped like a circular pillar or polygonal pillar, and an upper surface of the molding portion 122C may have a convex curved surface or a flat surface. Based on the upper surface of the support plate 101, an upper end of the molding portion 122C may be positioned higher than the height H2 of an upper end of the fixing frame 121C and higher than the height of the upper surface of the circuit board 110. The upper end of the molding portion (122C) may have a height higher than the height of the highest points of the first and second connection members 141 and 142 based on the upper surface of the support plate 101.

A portion of the molding portion 122C may extend to the upper surface of the circuit board 110. A portion of the molding portion 122C may extend above at least one of the first end portion 41 and the second end portion 43 of the first connection member 141. A portion of the molding portion 122C may extend above at least one of the first end portion 41 and the second end portion 43 of the second connection member 142. A portion of the molding portion 122C may extend above at least one of the first and second bonding pads 134 and 135. A portion of the molding portion 122C may extend above at least one of the first and second pads 111 and 112. A region where the molding portion 122C extends may include at least one or two or more of the above-described components, for example, the first end portion 41, the second end portion 43, the bonding pads 134 and 135, or the pads 111 and 112.

The first and second connection members 141 and 142 are respectively connected between the bonding pads 134 and 135 of the light source portion 130 and the pads 111 and 112 of the circuit board 110, and are extended on the fixing frame 121C. The molding portion 122C is formed inside the recess 106 and on the surface of the fixing frame 121C, and surrounds a portion of the first and second connection members 141 and 142, for example, a portion of the intermediate wire portion 42. Based on the upper surface of the support plate 101, the molding portion 122C may overlap the recess 106 in a vertical direction, protrudes above the highest points of the connection members 141 and 142, and supports and fixes a part of the connection member 141 and 142, that is, the intermediate wire portion 42.

A portion of the molding portion 122C may contact the inner surface of the recess 106 of the circuit board 110 or/and the upper surface of the circuit board 110. A portion of the molding portion 122C may contact the other side of the light source portion 130 and the upper surface of the support plate 101. A portion of the molding portion 122C may be in contact with the surface of the adhesive member 138. The fixing member 120C fixes and supports the connection members 141 and 142 on the region between the circuit board 110 and the light source portion 110, thereby preventing movement of the connection members 141 and 142 and preventing short circuit problems between the connection members 141 and 142 and the support plate 101.

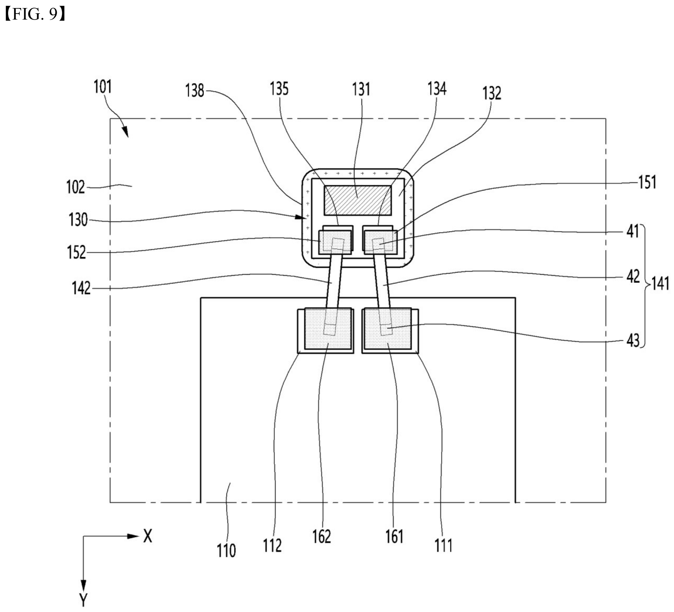

FIGS. 9 to 11 are diagrams of a lighting device according to a second embodiment of the invention.

Referring to FIGS. 9 to 11, the lighting device may include a support plate 101, a circuit board 110, a light source portion 130, a connection member 141 and 142, and a molding portion 151, 152, 161, and 162. The configuration of the support plate 101, circuit board 110, light source portion 130, and connection members 141 and 142 may include the configuration and description of the first embodiment disclosed above. The molding portions 151, 152, 161, and 162 include a resin material, and may include the configuration and description of the molding portion disclosed in the first embodiment. That is, the material of the molding portions 151, 152, 161, and 162 may include a resin material such as silicone or epoxy, acrylate, urethane, polyolefin, UV resin, or an insulating material, or may be an optional mixture thereof.

The molding portions 151, 152, 161, and 162 may include at least one molding portion disposed on the light source portion 130, and may include, for example, a first molding portion 151 and a second molding portion 152. The molding portions 151, 152, 161, and 162 may include at least one molding portion disposed on the circuit board 110, and may include, for example, a third molding portion 161 and a fourth molding portion 162. The first and second molding portions 151 may contact an upper surface of the light source portion 130 excluding the region of the light emitting device 131. The first and second molding portions 151 and 152 may be in contact with the surfaces of the bonding pads 134 and 135 and surrounding regions of the upper surface of the light source portion 130, excluding the region of the light emitting device 131. The third and fourth molding portions 161 and 162 may contact the surfaces of the pads 111 and 112 on the upper surface of the circuit board 110, or may contact the pads 111 and 112 and their surrounding regions.

The first molding portion 151 may be disposed on the first bonding pad 134 of the light source portion 130. The first molding portion 151 may be disposed on the first bonding pad 134 and the first end portion 41 of the first connection member 141. The first molding portion 151 covers the first end portion 41 of the first connection member 141 and contacts the upper surface of the first bonding pad 134. The first molding portion 151 may cover the surface of the first end portion 41 of the first connection member 141 and one end portion 42A of the intermediate wire portion 42. A portion of the first molding portion 151 may contact the upper surface of the resin member 132. An area of the lower surface of the first molding portion 151 may be 50% or more of an area of the upper surface of the first bonding pad 134, for example, in a range of 50% to 200% or 80% to 120%. When the area of the lower surface of the first molding portion 151 is smaller than the above range, the adhesive force between the first end portion 41 of the first connection member 141 and the first bonding pads 134 may decrease, and thus an open defect of the first end portion 41 of the first connection member 141 may occur, and oxidation problems of metals such as pads or wires may occur due to penetration of external moisture.

The second molding portion 152 may be disposed on the second bonding pad 135 of the light source portion 130. The second molding portion 152 may be disposed on the second bonding pad 135 and the first end portion 41 of the second connection member 142. The second molding portion 152 covers the first end portion 41 of the second connection member 142 and contacts the upper surface of the second bonding pad 135. The second molding portion 152 may cover the surface of the first end portion 41 of the second connection member 142 and one end portion 42A of the intermediate wire portion 42. A portion of the second molding portion 152 may contact the upper surface of the resin member 132. An area of the lower surface of the second molding portion 152 may be 50% or more of an area of the upper surface of the second bonding pad 135, for example, in a range of 50% to 200% or 80% to 120%. When the area of the lower surface of the second molding portion 152 is smaller than the above range, the adhesive force between the first end portion 41 of the second connection member 142 and the second bonding pads 135 may decrease and thus an open defect of the first end portion 41 of the second connection member 142 may occur, and oxidation problems in metals such as pads or wires may occur due to penetration of external moisture.

The first and second molding portions 151 and 152 may cover and secure one end portion 42A of the intermediate wire portion 42 of the first and second connection members 141 and 142. Accordingly, each of the first and second molding portions 151 and 152 may prevent a problem of cracking at a boundary portion or an end portion 42A between the intermediate wire portion 42 and the first end portion 41 of each of the first and second connection members 141 and 142.

The first and second molding portions 151 and 152 may be spaced apart from the light emitting device 131 of the light source portion 130. That is, the first and second molding portions 151 and 152 may be disposed on regions that deviate from the beam angle of light generated from the light emitting device 131. Accordingly, it is possible to prevent a decrease in the extraction efficiency of light generated from the light emitting device 131 or a decrease in the uniformity of the beam angle distribution.

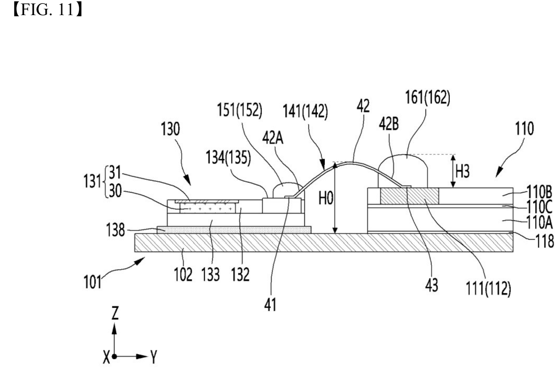

The third molding portion 161 may be disposed on the first pad 111 of the circuit board 110. The third molding portion 161 may be disposed on the first pad 111 and the second end portion 43 of the first connection member 141. The third molding portion 161 covers the second end portion 43 of the first connection member 141 and contacts the upper surface of the first pad 111. The third molding portion 161 may cover the surface of the second end portion 43 of the first connection member 141 and the other end portion 42B of the intermediate wire portion 42. A portion of the third molding portion 161 may contact the upper surface of the circuit board 110, that is, the upper surface of the protective layer 110B (see FIG. 11). An area of the lower surface of the third molding portion 161 may be 50% or more of an area of the upper surface of the first pad 111, for example, in a rage of 50% to 100% or 50% to 150%. When the area of the lower surface of the third molding portion 161 is smaller than the above range, the adhesive force between the second end portion 43 of the first connection member 141 and the first pads 111 may decrease and thus open defect of the second end portion 43 of the first connection member 141 may occur, and oxidation problems of metals such as pads or wires may occur due to penetration of external moisture.

The fourth molding portion 162 may be disposed on the second pad 112 of the circuit board 110. The fourth molding portion 162 may be disposed on the second pad 112 and the second end portion 43 of the second connection member 142. The fourth molding portion 162 covers the second end portion 43 of the second connection member 142 and contacts the upper surface of the second pad 112. The fourth molding portion 162 may cover the surface of the second end portion 43 of the second connection member 142 and the other end portion 42B of the intermediate wire portion 42. A portion of the fourth molding portion 162 may contact the upper surface of the circuit board 110, that is, the upper surface of the protective layer 110B (see FIG. 11). An area of the lower surface of the fourth molding portion 162 may be 50% or more of an area of the upper surface of the second pad 112, for example, in a range of 50% to 100% or 50% to 150%. When the area of the lower surface of the fourth molding portion 162 is smaller than the above range, the adhesive force between the second end portion 43 of the second connection member 142 and the second pads 112 may decrease and thus open defect of the second end portion 43 of the second connection member 142 may occur, and oxidation problems of metals such as pads or wires may occur due to penetration of external moisture.

The third and fourth molding portions 161 and 162 may cover and secure the other end portions 42B of the intermediate wire portions 42 of the first and second connection members 141 and 142. Accordingly, each of the third and fourth molding portions 161 and 162 may prevent a problem of cracking at a boundary portion or the other end portion 42B between the intermediate wire portion 42 and the second end portion 43 of each of the first and second connection members 141 and 142.

The first and second molding portions 151 and 152 and the third and fourth molding portions 161 and 162 may be spaced apart from each other by a distance greater than the distance D7 between the light source portion 130 and the circuit board 110. The straight length B0 of the connection members 141 and 142 is a straight length between both ends of each connection member 141 and 142, and may be greater than the distance D7 between the light source portion 130 and the circuit board 110.

Based on the upper surface of the circuit board 110, a height H3 of an upper end of the third and fourth molding portions 161 and 162 may be higher than a height of an upper end of the first and second molding portions 151 and 152. The height of the upper ends of the third and fourth molding portions 161 and 162 based on the upper surface of the support plate 101 may be higher than the height H0 of the highest point of the connection member 141 and 142. Accordingly, the upper ends of the third and fourth molding portions 161 and 162 can protect the upper portions of the connection members 141 and 142. The upper portions of the first and second molding portions 151 and 152 may be higher than the upper surface of the circuit board 110 based on the upper surface of the support plate 101, and may have the same height as the highest point as or different from the connection members 141 and 142. The upper surface or top view shape of the first and second molding portions 151 and 152 may be polygonal, circular, or oval. The upper surface or top view shape of the third and fourth molding portions 161 and 162 may be polygonal, circular or oval.

The first and second molding portions 151 and 152 may be spaced apart from each other, may contact each other as a modified example described later, or may be formed integrally. The third and fourth molding portions 161 and 162 may be spaced apart from each other, may contact each other as a modified example described later, or may be formed integrally. The first and third molding portions 151 and 161 may be spaced apart from each other, may contact each other as a modified example described later, or may be formed integrally. The second and fourth molding portions 152 and 162 may be spaced apart from each other, may contact each other as a modified example described later, or may be formed integrally. As another example, at least a portion of the first and second molding portions 151 and 152 extends to the other side of the light source portion 130 and may contact the upper surface of the support plate 101. At least a portion of the third and fourth molding portions 161 and 162 extend to one side of the circuit board 110 and may contact the upper surface of the support plate 101.

The minimum interval E1 between the first end portions 41 of the first and second connection members 141 and 142 may be less than or equal to the minimum interval E2 between the second end portions 43 of the first and second connection members 141 and 142. For example, the minimum interval E1 and E2 may satisfy the condition E1 ≤ E2, and preferably, E1 < E2. This can increase an area of the first and second pads 111 and 112 on the circuit board 110, and the interval between the first and second pads 111 and 112 may be increased than the interval between the first and second bonding pads 134 and 135. Accordingly, within the minimum interval E1 and E2, E2 may be greater than 1 time to less than 2 times the interval E1. When the minimum interval E2 may be greater than the above range, the material of the connection members 141 and 142 may be wasted, and each end portion 41 and 43 may be tilted due to the interval between the connection members 141 and 142. Accordingly, it may become difficult to secure the bonding equipment for bonding each end portion 41 and 43. The minimum interval E1 between the first end portions 41 of the first and second connection members 141 and 142 may be greater than the width W of the connection members 141 and 142, for example, 1 mm or more or 1 mm to 6 mm.

The inner angle between two virtual straight lines extending in the longitudinal direction of the first and second connection members 141 and 142 may be 1 degree or more, for example, in the range of 1 degree to 90 degrees or in the range of 10 degrees to 60 degrees. If the inner angle is smaller than the above range, the adhesive area of the molding portion on the circuit board 110 may be reduced. This can support the second end portion 43 of the connection members 141 and 142 by a molding portion having a larger area on the circuit board 110.

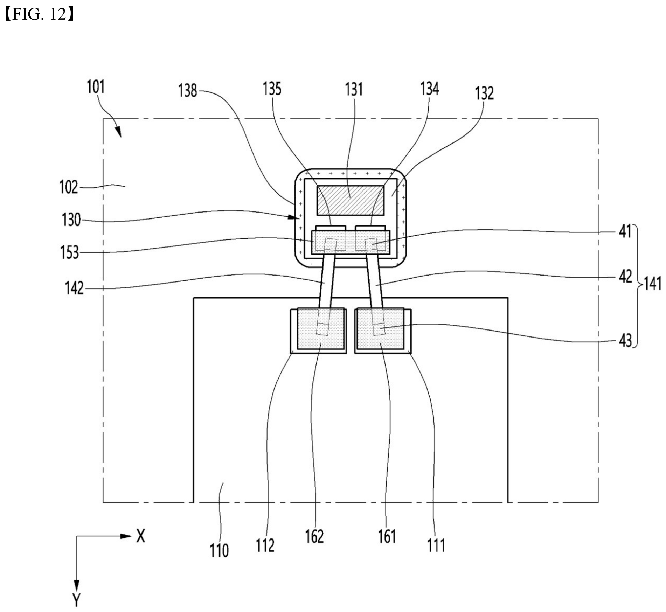

FIGS. 12 to 21 show modified examples of the lighting device of the second embodiment.

As shown in FIG. 12, the first molding portion 153 has a shape in which the first and second molding portions 151 and 152 shown in FIG. 9 are connected. The first molding portion 153 may be disposed on the surfaces of the first and second bonding pads 134 and 135 of the light source portion 130. The first molding portion 153 may be further disposed on a region between the first and second bonding pads 134 and 135, that is, on the surface of the resin member 132. The first molding portion 153 may extend from the region of the first and second bonding pads 134 and 135 to a region adjacent to the other side of the light source portion 130. The first molding portion 153 may cover a first end portion 41 of the first and second connection members 141 and 142 and an end portion 42A of the intermediate wire portion 42.

The third and fourth molding portions 161 and 162 cover the second end portions 43 of the connection members 141 and 142 disposed on each of the third and fourth pads 111 and 112 of the circuit board 110 and may cover and protect the other end 42B of the intermediate wire portion 42 of the connection members 141 and 142. The lower surface area of each of the third and fourth molding portions 161 and 162 may be smaller than the lower surface area of the first molding portion 153.

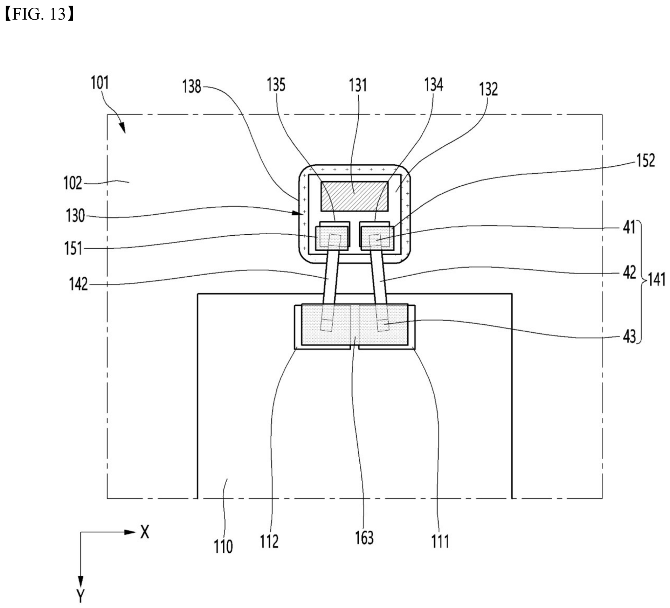

As shown in FIG. 13, the third molding portion 163 has a shape in which the third and fourth molding portions 161 and 162 shown in FIG. 9 are connected. The third molding portion 163 may be disposed on the surfaces of the first and second pads 111 and 112 of the circuit board 110. The third molding portion 163 may be further disposed on a region between the first and second pads 111 and 112. The third molding portion 163 may extend from a region of the first and second pads 111 and 112 adjacent to a side surface of the circuit board 110, that is, an upper surface of the protective layer 110B (see FIG. 11) of the circuit board 110. The third molding portion 163 may cover and protect the second end portion 43 of the first and second connection members 141 and 142, and the other end portion 42B which is a boundary portion between the second end portion 43 and the intermediate wire portion 42. The sum of the lower surface areas of the first and second molding portions 151 and 152 may be smaller than the lower surface area of the third molding portion 163.

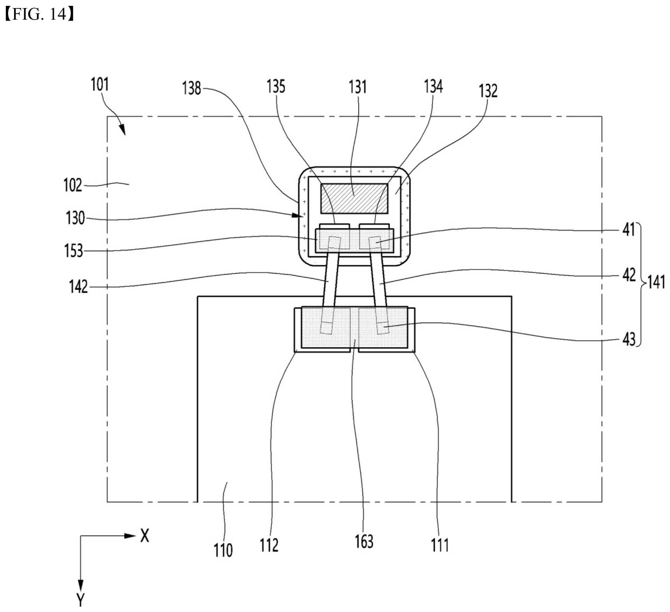

Referring to FIG. 14, in the lighting device, the first molding portion 153 has a shape in which the first and second molding portions shown in FIG. 9 are connected, and the second molding portion 163A has a shape in which the third and fourth molding portions shown in FIG. 9 are connected. The first molding portion 153 may be disposed on the surfaces of the first and second bonding pads 134 and 135 of the light source portion 130. The first molding portion 153 may be further disposed on a region between the first and second bonding pads 134 and 135, that is, on the surface of the resin member 132. The first molding portion 153 may extend from the region of the first and second bonding pads 134 and 135 to a region adjacent to the other side of the light source portion 130. The first molding portion 153 may cover a first end portion 41 of the first and second connection members 141 and 142 and an end portion 42A of the intermediate wire portion 42. The second molding portion 163A may be disposed on the surfaces of the first and second pads 111 and 112 of the circuit board 110. The second molding portion 163A may be further disposed on a region between the first and second pads 111 and 112. The second molding portion 163A may extend from a region of the first and second pads 111 and 112 to a region adjacent to one side surface of the circuit board 110, that is, an upper surface of the protective layer 110B (see FIG. 11) of the circuit board 110. The second molding portion 163A may cover the second end portion 43 of the first and second connection members 141 and 142 and the other end portion 42B of the intermediate wire portion 42. Additionally, the second molding portion 163A may cover the other end portion 42B of the intermediate wire portion 42 of the connection members 141 and 142. The lower surface area of the second molding portion 163A may be larger than the lower surface area of the first molding portion 153.

Since the first molding portion 153 is molded on the first end portions 41 of the first and second connection members 141 and 142, the occurrence of cracks in the boundary portion between the first end portions 41 and the intermediate wire portions 42 can be prevented. Since the second molding portion 163A is molded on the second end portions 43 of the first and second connection members 141 and 142, the occurrence of cracks in the boundary portion between the third end portions 43 and the intermediate wire portions 42 can be prevented.

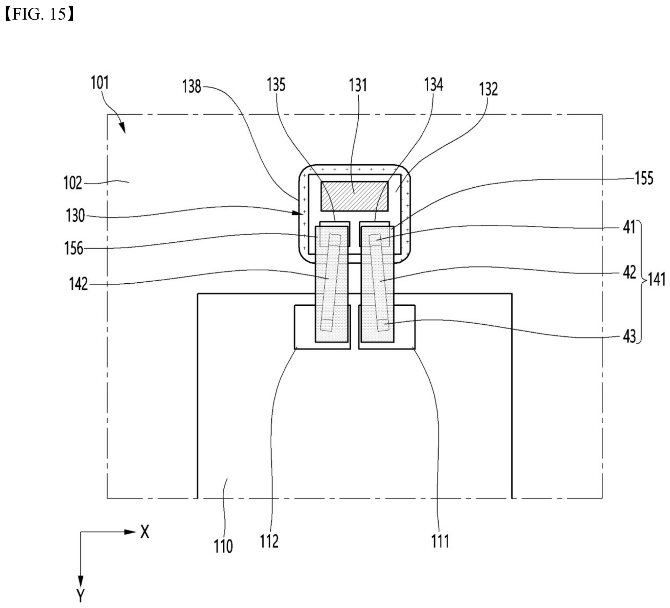

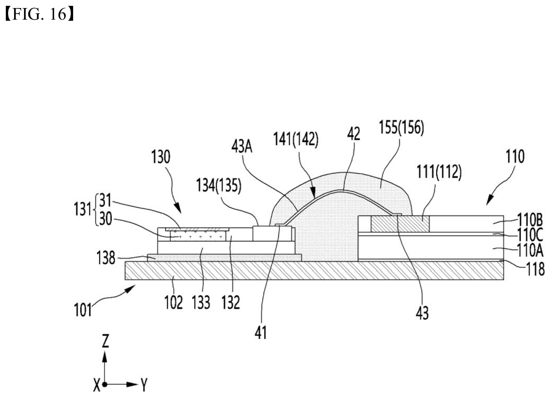

Referring to FIGS. 15 and 16, in the lighting device, the first molding portion 155 is disposed on the first connection member 141, and the second molding portion 156 is disposed on the second connection member 142. At least part or all of the first molding portion 155 and the second molding portion 156 may be separated from each other. The interval between the first molding portion 155 and the second molding portion 156 may be smaller than the minimum interval between the first and second connection members 141 and 142. The interval between the first and second connection members 141 and 142 may satisfy the minimum distance E1 or more or the maximum distance E2 or less shown in FIG. 10. The interval between the first molding portion 155 and the second molding portion 156 may be the same depending on the region or may widen from the bonding pads 134 and 135 of the light source portion 130 to regions adjacent to the first and second pads 111 and 112 of the circuit board 140. In the second direction Y, the first and second molding portions 155 and 156 may have a length longer than the length of the first and second connection members 141 and 142. The width of the first molding portion 155 and the second molding portion 156 in the first direction X may be constant or some regions may be formed differently.

The first molding portion 155 may cover the first end portion 41, the intermediate wire portion 42, and the second end portion 43 of the first connection member 141, and may be disposed on a region between the light source portion 130 and the circuit board 110. The second molding portion 156 may cover the first end portion 41, the intermediate wire portion 42, and the second end portion 43 of the second connection member 142, and may be disposed on a region between the light source portion 130 and the circuit board 110. Each of the first and second molding portions 155 and 156 may contact the other side of the light source portion 130, one side of the circuit board 110, and the upper surface of the support plate 101. Each of the first and second molding portions 155 and 156 may overlap the first and second connection members 141 and 142 in a vertical direction with respect to and the upper surface of the support plate 101, and for example, may overlap the first end portions 41, the intermediate wire portions 42, and the second end portions 43 of the first and second connection members 141 and 142 in the vertical direction.

The height of the highest point of each of the first and second molding portions 155 and 156 based on the upper surface of the support plate 101 may be higher than the height of the highest point of the first and second connection members 141 and 142. Accordingly, the first and second molding portions 155 and 156 can protect the surfaces of the first and second connection members 141 and 142. The heights of the uppermost ends of the first and second molding portions 155 and 156 with respect to the upper surface of the support plate 101 may be the same or different, and the side cross section of the first and second molding portions 155 and 156 in the second direction Y may have circular, elliptical or polygonal shape.

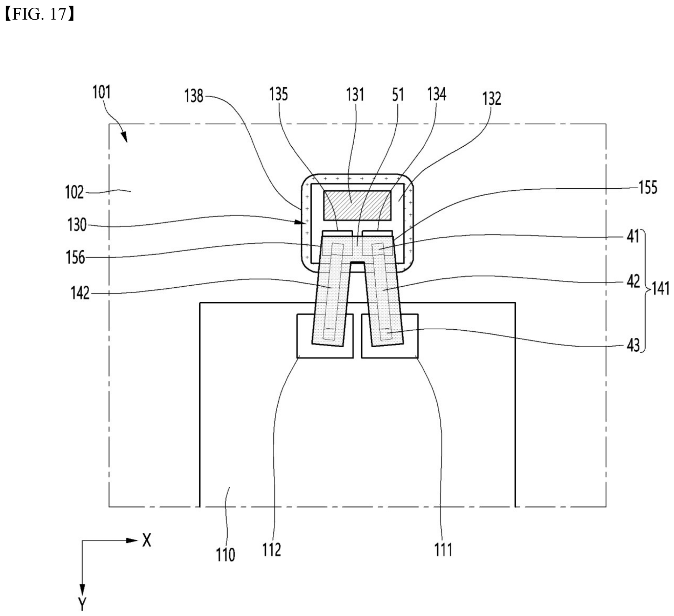

FIG. 17 is a modified example of FIG. 15, in which the first and second molding portions 155 and 156 may be connected to each other on the light source portion 130. That is, the first and second molding portions 155 and 156 may include a first connection portion 51 connected to each other. The first connection portion 51 may be a region where the first and second molding portions 155 and 156 are connected to each other on the light source portion 130. The first connection portion 51 may be disposed in a region between the first bonding pad 134 and the second bonding pad 135 of the light source portion 130 and may be in contact with the surface of the resin member 132. The first connection portion 51 may be disposed on the upper surface of the light source portion 130, or may extend from the upper surface of the light source portion 130 to a portion of the upper surface of the support plate 101. The first connection portion 51 may be spaced apart from the light emitting device 131.

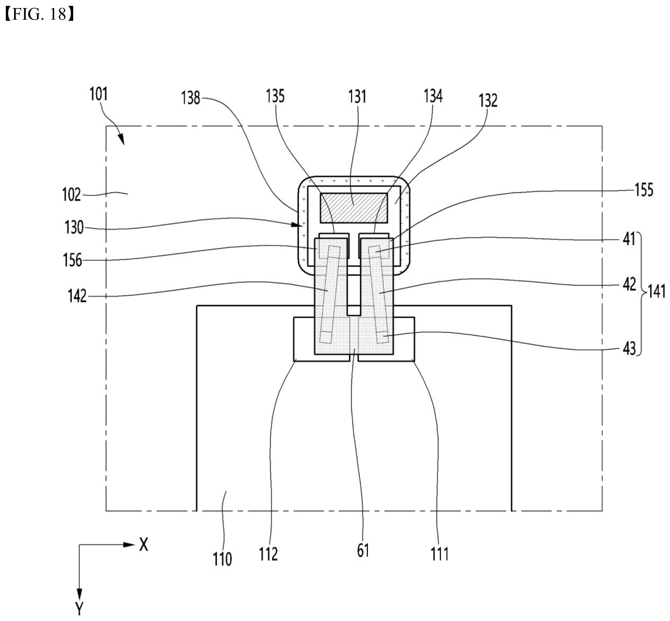

FIG. 18 is a modified example of FIG. 15, in which the first and second molding portions 155 and 156 may be connected to each other on the circuit board 110. That is, the first and second molding portions 155 and 156 may include a second connection portion 61 connected to each other. The second connection portion 61 may be a region where the first and second molding portions 155 and 156 are connected to each other on the circuit board 110. The second connection portion 61 may be disposed in a region between the first pad 111 and the second pad 112 of the circuit board 110 and may be in contact the surface of the protective layer 110B (see FIG. 11). The second connection portion 61 may be disposed on the upper surface of the circuit board 110, or may extend from the upper surface of the circuit board 110 to a portion of the upper surface of the support plate 101.

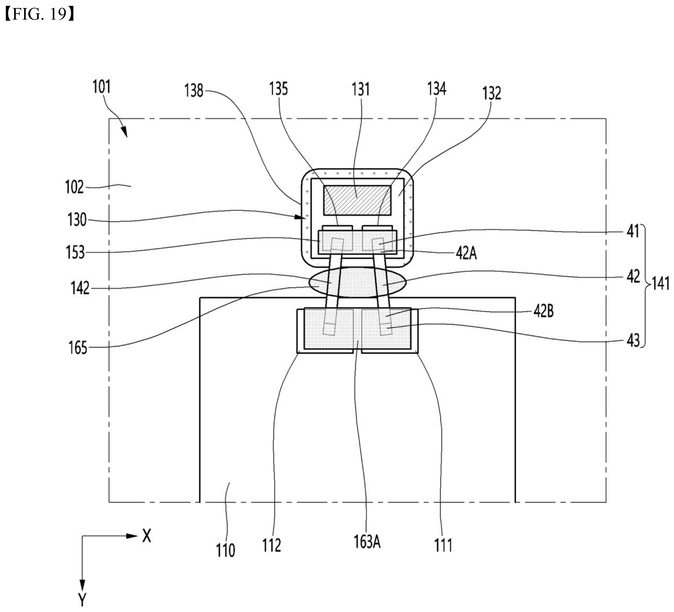

FIG. 19 is a modified example of FIG. 14, and in the lighting device, the molding portion may be disposed in different regions of the connection members 141 and 142, for example, in two regions, three regions, or more. The first molding portion 153 may cover the first and second bonding pads 134 and 135 and the first end portions 41 of the first and second connection members 141 and 142 and the one end portion 42A of the intermediate wire portion 42 on the light source part 130. The second molding portion 163A may cover the first and second pads 111 and 112, second end portions 43 of the first and second connection members 141 and 142, and the other end portion 42B of the intermediate wire portion 42 on the circuit board 110. A height of an uppermost end of the second molding portion 163A with respect to an upper surface of the support plate 101 may be higher than a height of an uppermost end of the intermediate wire portion 42.

The central molding portion 165 may be disposed on a region in the second direction Y of the first and second connection members 141 and 143, and may be located at the center region of at least one or both of the first and second connection members 141 and 143. The central molding portion 165 may cover at least a portion of the intermediate wire portion 42 of the first and second connection members 141 and 143. The central molding portion 165 may cover a region of the highest point of the intermediate wire portions 42. The central molding portion 165 may be disposed between the first molding portion 153 and the second molding portion 163A.

The central molding portion 165 may cover the upper surface of the intermediate wire portion 42 on the support plate 101 and may have an upper end that is higher than the highest point of the intermediate wire portion 42. The lower portion of the central molding portion 165 may be disposed in a region between the intermediate wire portion 42 and the support plate 101. The central molding portion 165 may be spaced apart from the first and second molding portions 153 and 163A in a region between the first molding portion 153 and the second molding portion 163A. As another example, the lower portion of the central molding portion 165 may be connected to at least one or both of the first and second molding portions 153 and 163A. The lower portion of the central molding portion 165 may contact the surface of the adhesive member 138 and the light source portion 130. The lower portion of the central molding portion 165 may be in contact with one side of the circuit board 110, or may be in contact with both one side and the upper surface of the circuit board 110.

Since the molding portions 153, 163A, and 165 mold on different regions of the first and second connection members 141 and 142, and may protect each end portion 41 and 43 and the region of the highest point of the first and second connection members 141 and 142.

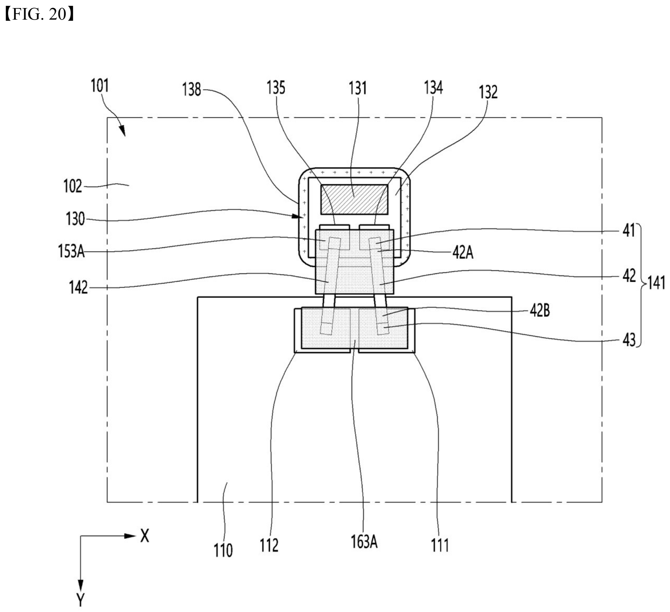

Referring to FIG. 20, in the lighting device, the molding portion may be disposed in different regions of the connection members 141 and 142, for example, in two or more regions. The first molding portion 153A may cover the first and second bonding pads 134 and 135, the first end portions 41 of the first and second connection members 141 and 142, and the one end portion 42A of the intermediate wire portion 42 on the light source portion 130. The second molding portion 163A may cover the first and second pads 111 and 112, the second end portions 43 of the first and second connection members 141 and 142, and the other end portion 42B of the intermediate wire portion 42 on the circuit board 110.

The first molding portion 153A may extend to a region of the highest point of the intermediate wire portion 42 of the first and second connection members 141 and 142. The first molding portion 153A may contact the other side surface of the light source portion 130, the adhesive member 138, and the upper surface of the support plate 101. Additionally, the lower portion of the first molding portion 153A may be further disposed at a lower portion of the intermediate wire portions 42. The height of the uppermost point of the first molding portion 153A based on the upper surface of the support plate 101 may be higher than the height of the highest point of the intermediate wire portion 42. Among the regions of the first molding portion 153A, the side surface closest to one side surface of the circuit board 110 is spaced apart from one side surface of the circuit board 110, or at least a portion of thereof may contact one side surface of the circuit board 110.

The first molding portion 153A and the second molding portion 163A may be separated from each other, or at least a portion thereof may be in contact with each other. The lower surface area of the first molding portion 153A may be larger than the lower surface area of the second molding portion 163A. The first molding portion 153A can support a region of the one end portions 42A of the connection members 141 and 142 and the other side region of the light source portion 130, thereby preventing the flow of the one end portions 42A of the connection members 141 and 142 and the light source portion 130.

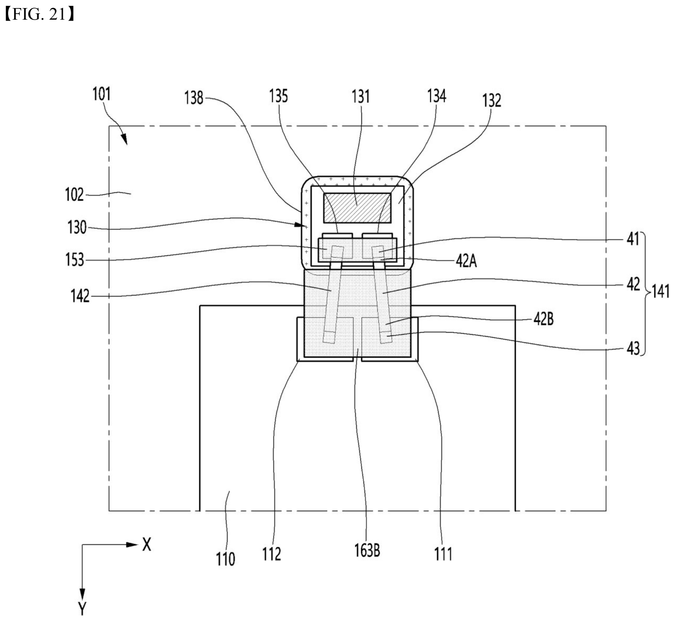

Referring to FIG. 21, in the lighting device, the molding portion may be disposed on different regions of the connection members 141 and 142, for example, in two or more regions. The first molding portion 153 may cover the first and second bonding pads 134 and 135, the first end portions 41 of the first and second connection members 141 and 142, and the one end portion 42A of the intermediate wire portion 42 on the light source portion 130. The second molding portion 163B may cover the first and second pads 111 and 112, the second end portions 43 of the first and second connection members 141 and 142, and the other end portion 42B of the intermediate wire portion 42 on the circuit board 110.

The second molding portion 163B may extend to a region of the highest point of the intermediate wire portion 42 of the first and second connection members 141 and 142. The second molding portion 163B may be in contact with one side surface of the circuit board 110, the upper surface of the support plate 101, and the adhesive member 138. The lower portion of the second molding portion 163B may be further disposed at the lower portion of the intermediate wire portions 42. The height of the uppermost point of the second molding portion 163B based on the upper surface of the support plate 101 may be higher than the height of the highest point of the intermediate wire portion 42. Among the regions of the second molding portion 163B, the surface closest to the other side surface of the light source portion 130 is spaced apart from the other side surface of the light source portion 130, or at least a portion of the region may contact to the other side surface of the light source portion 130.

The first molding portion 153A and the second molding portion 163B may be separated from each other, or at least a portion thereof may be in contact with each other. The lower surface area of the second molding portion 163B may be larger than that of the first molding portion 153A. The second molding portion 163B can support a region of the other end portions 42B of the connection member 141 and 142 and a region of the one side of the circuit board 110, thereby preventing a movement between the other end portions 42B of the connection member 141 and 142 and the intermediate wire portion 42.

FIG. 22a is another example of a support plate of the lighting device of FIG. 11.

As shown in FIG. 22a, the support plate 101 may include a concave receiving portion 108 at the upper portion thereof. Accordingly, a stepped bottom portion 102A of the upper portion 102 of the support plate 101 may be disposed lower than the upper surface of the upper portion 102.

The receiving portion 108 may be provided in a size into which the circuit board 110 may be inserted. The depth of the receiving portion 108 may be 0.5 times or more, for example, 0.5 to 1.5 times the thickness of the circuit board 110. If the depth of the receiving portion 108 is greater than the above range, rigidity may be reduced in the stepped region of the upper portion 102, and if it is less than the above range, the effect of lowering the height of the high point of the wire may be reduced. The molding portions 151, 152, 161, and 162 can be applied to the embodiment of FIG. 11, and can also be applied to the embodiments of FIGS. 12 to 21 disclosed above. Additionally, the configuration having the receiving portion 108 can be applied to the embodiments of FIGS. 4a to 8. That is, the circuit board 110 disclosed in the above embodiment or modified example may be applied to the stepped bottom portion 102A of the upper portion 102. Since the height of the upper surface of the circuit board 110 can be lowered based on the upper surface of the support plate 101, the difference between the height of the upper surface of the light source portion 130 and the height of the upper surface of the circuit board 110 can be reduced. Accordingly, the difference between the height of the upper surfaces of the bonding pads 134 and 135 of the light source portion 130 and the height of the upper surfaces of the pads 111 and 112 of the circuit board 110 may be reduced, and the connection members 141 and 142 may lower an inclination angle extending from each of the ends 41 and 43 to the intermediate wire portion 42, and may suppress the occurrence of cracks in a region between each of the end portions 41 and 43 and the intermediate wire portion 42.

As shown in FIG. 22b, the bonding pads 134 and 135 of the light source portion 130 may be disposed on a region lower than the upper surface of the resin member 132. Accordingly, the difference between the height of the upper surfaces of the bonding pads 134 and 135 of the light source portion 130 and the height of the upper surfaces of the pads 111 and 112 of the circuit board 110 can be reduced, and the connection members 141 and 142 may lower an inclination angle extending from each of the ends 41 and 43 to the intermediate wire portion 42, and may suppress the occurrence of cracks in a region between each of the end portions 41 and 43 and the intermediate wire portion 42.

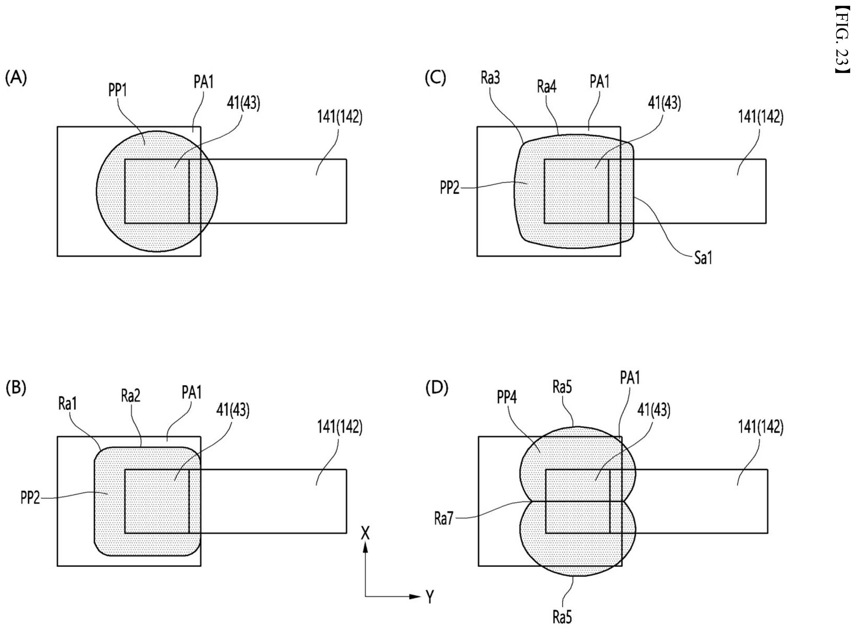

FIG. 23 is an example showing the shape of the molding portion of the embodiment disclosed above. The shape of the molding portion represents a top view shape, and the shape extending along the outer line may include at least one or two of straight lines, curves, concave or convex shapes. In the shape of the side cross section of the molding portion in the first direction X or the second direction Y, the outline line may include at least one or two of a convex curved surface, a concave curved surface, and an uneven shape.

As shown in (A) of FIG. 23, a pad PA1 is connected to the light source portion or circuit board, and the end portions 41 and 43 of the connection members 141 and 142 are connected to the pad PA1. The molding portion PP1 is disposed on the pad PA1 and can seal the entire region of each end portion 41 and 43. The top view shape of the molding portion PP1 may be circular or elliptical, and the side cross section may be hemispherical or bar elliptical.

As shown in (B) of FIG. 23, the end portions 41 and 43 of the connection members 141 and 142 are connected to the pad PA1 on the light source portion or circuit board, and the molding portion PP2 is disposed on the pad PA1 and can seal the entire region of each end portion 41 and 43. The top view shape of the molding portion PP2 may be a polygonal shape, for example, a square shape or more (e.g., pentagonal, hexagonal, or octagonal shape), and each corner portion Ra1 of the polygonal shape may be an angled surface or a curved surface. and each side surface Ra2 may have a straight shape.

As shown in (C) of FIG. 23, the end portions 41 and 43 of the connection members 141 and 142 are connected to the pad PA1 on the light source portion or circuit board, and the molding portion PP2 is disposed on the pad PA1 and can seal the entire region of each end portion 41 and 43. The top view shape of the molding portion PP2 may be a polygonal shape, for example, a square shape or a larger shape, and each corner portion Ra1 of the polygonal shape may be an angled surface or a curved surface, and is disposed on the pad PA1. The side surfaces Ra4 may have a convex curved shape, and the side surface Sa1 deviating from the pad PA may have a straight shape or a curved shape.

As shown in (D) of FIG. 23, the end portions 41 and 43 of the connection members 141 and 142 are connected to the pad PA1 on the light source portion or circuit board, and the molding portion PP4 is disposed on the pad PA1 and can seal the entire region of each end portion 41 and 43. The top view shape of the molding portion PP4 may be symmetrical on both sides with respect to the center line, and the symmetrical shape may be a semicircular or semielliptical shape. The outer circular line of the molding portion PP4 may be a convex curved surface Ra5, and both ends of the central line may have concave regions Ra7. As another example, the shape formed on both sides of the center line may be the same, but the formed surface area may be different.

In the lighting device according to an embodiment of the invention, as shown in FIG. 24, light emitted from the light source portion 130 may be extracted through the light guide module 500 made of a transparent material. The lighting device disclosed above can be defined as a light source module.

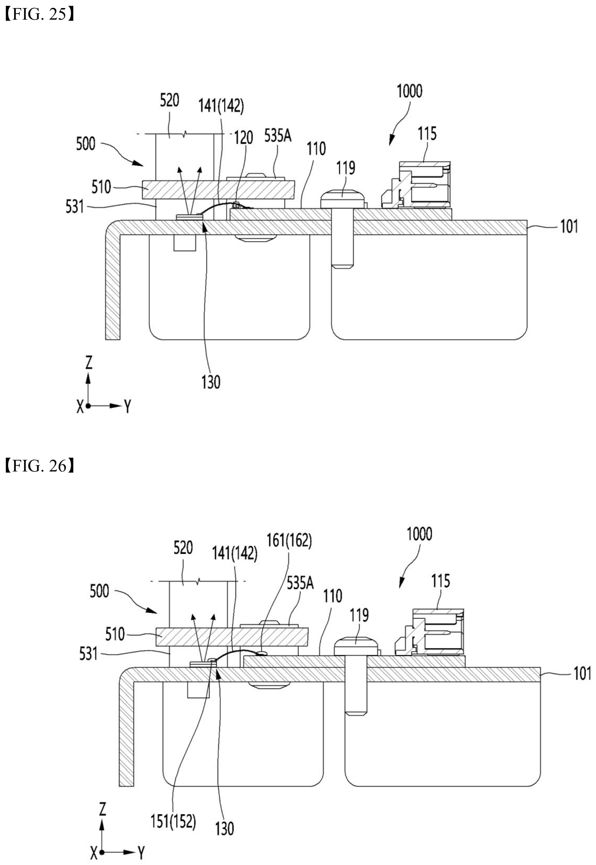

As shown in FIGS. 24 and 25, the light guide module 500 includes a transparent plate 510 and a light guide portion 520, and the transparent plate 510 may be made of a transparent plastic material, and the light guide portion 520 protrudes on the transparent plate 510 and may be made of a transparent plastic material. The transparent plastic material may include PC and PMMA materials. The transparent plate 510 and the light guide portion 520 may be made of the same material. The transparent plate 510 and the light guide portion 520 may be formed integrally with a transparent material.

The transparent plate 510 aligns the position between the light source portion 130 and the light guide portion 520 and may be coupled to the support plate 101. Additionally, the transparent plate 510 may cover the upper perimeter of the light source portion 130 so that light emitted from the light source portion 130 is effectively incident on the light guide portion 520.

The lower or upper surface of the transparent plate 510 may be arranged parallel to the upper surface of the support plate 101. The transparent plate 510 is spaced a predetermined distance from the upper surface of the support plate 101 and, for example, may be positioned higher than the height of the upper portion of the fixing member 120 of FIG. 1, for example, 2.5 mm or more, for example, in a range of 2.5 mm to to 7 mm.

The light guide portion 520 is provided in a pillar shape and may include, for example, a circular pillar or a polygonal pillar shape. The light guide portion 520 may have a narrow lower area and a larger upper area depending on the beam angle distribution of the light source portion 130. The beam angle of the light source portion 130 may be 70 degrees or more, for example, in the range of 70 degrees to 150 degrees.

The light guide portion 520 may overlap the light source portion 130 in a vertical direction. The light guide portion 520 emits point light from the light source portion 130 as surface light. The light guide portion 520 may have an area of a lower surface and/or an area of an upper surface that are larger than an area of the upper surface of the light source portion 130.

The light guide portion 520 may have a diameter or width greater than the length D5 (see FIG. 10) of one side of the light source portion 130, for example, 1.5 times or more than the length of one side of the light source portion 130, preferably 5 mm or more, for example, may range from 5 mm to 10 mm. If the diameter or width of the light guide portion 520 is smaller than the above range, the amount of incident light may be reduced, and if it is larger than the above range, the light intensity or light intensity distribution may be reduced.

The transparent plate 510 includes a first support protrusion 531 and a second support protrusion 535 at the lower portion, and the first support protrusion 531 is disposed on both sides of the outer lower portion of the transparent plate 510, the second support protrusion 535 may be disposed on both sides of the inner lower portion. Here, the inside may be the direction of the circuit board 110 disposed at the center of the support plate 101. The transparent plate 510 may be coupled to the support plate 101 through the first support protrusion 531 and the second support protrusion 535 by a fastening means. A coupling portion 535A coupled to the first and second support protrusions 531 and 535 may be disposed on the upper surface of the transparent plate 510, or a washer or nut may be coupled thereto.

This light guide module 500 can extract light, such as white light, emitted through the light source portion 130 of the lighting device 1000 to the outside. In addition, the light guide portion 520 is disposed in the direction in which the highest light intensity is emitted from the light source portion 130, and since the light is incident, it can be emitted to the outside without light loss.

The lighting device of FIG. 25 is an example of fixing the connection members 141 and 142 on the circuit board 110 shown in FIG. 5 with the fixing member 120 disclosed above. The lighting device of FIG. 26 is an example in which molding portions 151, 152, 161, and 162 fix connection members 141 and 142 on the light source portion 130 and the circuit board 110, respectively, as shown in FIG. 11. This connection member can be selectively applied and fixed among the embodiments or modified examples disclosed above.

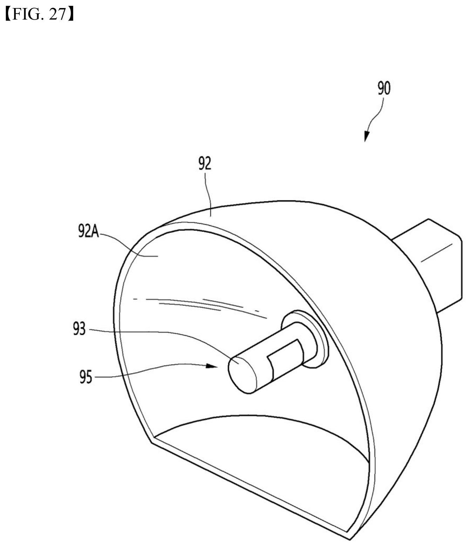

Referring to FIG. 27, a vehicle headlamp 90 having a lighting device according to an embodiment includes a light source module 93 and a housing 92, and the light source module 93 may be disposed inside the housing 92 to emit light, and the irradiated light may be reflected in the exit direction through the inner surface 92A of the housing 92. The housing 92 has a cavity 95 inside, and the cavity 95 is a region open in the emission direction or on one side, and the light source module 93 can be coupled therein. The light source module 93 may include the lighting device disclosed above. The shape of the cavity 95 may be a hemispherical shape, a semi-elliptical shape, a circular shape, or an elliptical shape when viewed from the exit or opening direction.

The housing 92 may include metal or non-metallic material, and the non-metallic material may include plastic material. The housing 92 may be a reflector of a headlamp. The inner surface 92A of the housing 92 or the inner surface 92A of the cavity 95 may be a surface coated with a highly reflective material, or may include a reflective layer having an anti-reflection (AR) material. For example, the highly reflective material may include at least one of metals such as Al, Ag, and Au, and the anti-reflective material may include at least one of MgF₂, Al₂O₃, SiO, SiO₂, TiO₂+ZrO₂, TiO₂, and ZrO₂. The reflective layer of the inner surface 92A may be a single layer or a multilayer. Since the cavity 95 is provided with a reflective material around it, it can function as a reflective cup.

The headlamp 90 may include an inner lens and/or an outer lens that projects light emitted through the housing 92. The light distribution pattern of light emitted from the light source module 93 can be adjusted depending on the shape of the inner lens or the number of light source portions. The light source module 93 selectively radiates light of a high beam distribution pattern and a low beam distribution pattern, and the high beam distribution pattern or the low beam distribution pattern can be automatically turned on and off depending on the driving mode or driving situation.

The inner surface 92A of the housing 92 may include a partially domed or partially elliptical paraboloid. The inner surface 92A may have a plurality of facets. The facets may be free-form, flat, and/or curved (e.g., concave or convex) members. In some examples, a single facet may have a free-shaped portion, and/or a flat portion, and/or a curved portion (e.g., any combination thereof). In some embodiments, a facet (or at least an inward-facing face on a facet) may be at least approximated, or otherwise determined by an algebraic equation. For example, the shape of a facet or inward-facing surface can be expressed by one or more 5th order algebraic equations (of course, other equations of any order are possible). In at least one example embodiment, the surface (or, e.g., coating) of the facet has a high reflectivity (e.g., greater than 80% reflectivity). Nonlimiting examples of facets and/or coatings on facets include aluminum and silver, but other reflective materials may be used.

The inner surface 92A of the housing 92 is laterally spaced from the light source module 93, and the light emitted from the light source module 93 is reflected by the inner surface 92A, condensed toward the emission side of the hosing 92, and can be irradiated as a high beam or low beam. The outside of the housing 92 may include various features and accessories for mounting or connecting the headlamp 90 to the interior of the vehicle, and may have an electrical interface, such as a socket, for connecting power and/or signals. The housing 92 and cavity 95 described above are examples and may be changed into various shapes. The housing 92 according to the embodiment may function as a reflector for the left and right head lamps 90.

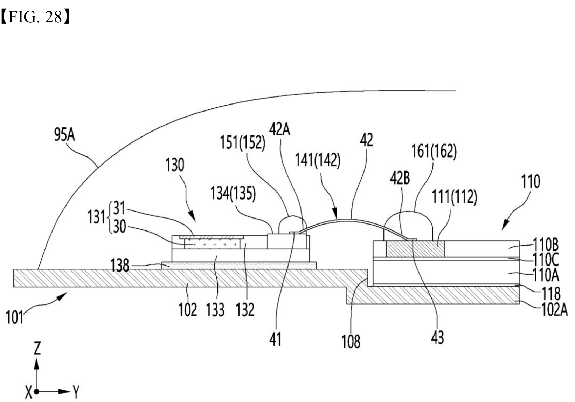

Another example of a lamp is an example in which a reflector is applied to a lighting device as shown in FIG. 28. The lighting device disclosed in the embodiment or modified example may be applied to the lighting device.

As shown in FIG. 28, the lower end of the reflector 95A may be disposed on the upper portion 102 of the support plate 101. The lower end of the reflector 95A may be disposed on a region adjacent to the light source portion 130 disposed on the support plate 101. The lower end of the reflector 95A may be provided in a form that surrounds at least three sides and an upper surface of the light source portion 130. The region between the upper end of the reflector 95A and the upper end of the support plate 101 may be a region where light is emitted. The inside of the reflector 95A, that is, the region between the reflector 95A and the upper end of the support plate 101, is an open region and may be a region where light is mixed.

The vertical distance between the upper end of the reflector 95A and the upper surface of the support plate 101 may be greater than the distance between the upper surface of the light source portion 130 and a virtual straight line perpendicular to the upper surface of the light source portion 130 and a point where the reflector 95A intersect. Accordingly, the reflector 95A can emit light emitted from the light source portion 130 in the side direction. Here, the lateral direction is a direction away from the straight line perpendicular to the light source portion 130 and is the direction in which the light reflected by the reflector 95A and the light emitted from the light source portion 130 are emitted. As another example, the lower end of the reflector 95A may be disposed on the circuit board 110. As another example, the lower end of the reflector 95A may be disposed on the circuit board 110 and the upper portion 102 of the support plate 101. The emission direction of light may vary depending on the position of the reflector 95A, and for example, the emission direction of light between the support plate 101 and the reflector 95A may be at least one of directions orthogonal to a virtual straight line perpendicular to the light source portion 130.

Features, structures, effects, etc. described in the above embodiments are included in at least one embodiment of the invention, and are not necessarily limited to only one embodiment. Furthermore, features, structures, effects, etc. illustrated in each embodiment can be combined or modified for other embodiments by those of ordinary skill in the art to which the embodiments belong. Accordingly, the contents related to such combinations and modifications should be interpreted as being included in the scope of the invention. In addition, although the embodiments have been mainly described above, this is only an example and does not limit the present invention, and one of ordinary skill in the field to which the present invention belongs will appreciate that various modifications and applications not illustrated above may be possible without departing from the essential characteristics of the present embodiment. For example, each component specifically shown in the embodiment can be implemented by modification. And differences related to such modifications and applications should be construed as being included in the scope of the invention defined in the appended claims.

## Claims

1. A lighting device comprising:
a support plate;
a circuit board disposed on the support plate;
a plurality of pads disposed on one side of the circuit board;
a light source portion disposed on the support plate and having a light emitting device and a plurality of bonding pads;
a plurality of connection members respectively connecting the plurality of pads to the plurality of bonding pads; and
a plurality of molding portions covering different region of at least one of the plurality of connection members,
wherein an uppermost end of at least one of the plurality of molding portions is disposed higher than positions of highest points of the plurality of connection members based on the upper surface of the circuit board.

2. The lighting device of claim 1,
wherein the plurality of pads includes a first pad and a second pad adjacent to the light source portion,
wherein the plurality of bonding pads includes a first bonding pad and a second bonding pad adjacent to the circuit board,
wherein the plurality of connection members includes a first connection member connecting the first pad and the first bonding pad, and a second connection member connecting the second pad and the second bonding pad, and
wherein the uppermost end of at least one of the plurality of molding portions is disposed higher than positions of highest points of the first and second connection members based on the upper surface of the circuit board.

3. The lighting device of claim 2,
wherein the plurality of molding portions includes a first molding portion disposed on a first end portion of the first connection member connected to the first pad of the light source portion, and a second molding portion disposed on a first end portion of the second connection member connected to the second pad of the light source portion.

4. The lighting device of claim 3,
wherein the first and second molding portions are connected to each other on a region between the first pad and the second pad.

5. The lighting device of claim 4,
wherein a region of the first and second molding portions connected to each other extends to a region between the light source portion and the circuit board and covers the intermediate wire portion of the first and second connection members.

6. The lighting device of claim 2 or 3,
wherein the plurality of molding portions includes a third molding portion disposed on a second end portion of the first connection member connected to the first bonding pad of the circuit board, and a fourth molding portion disposed on a second end portion of the second connection member connected to the second bonding pad of the circuit board.

7. The lighting device of claim 6,
wherein the third molding portion and the fourth molding portion are connected to each other on a region between the first bonding pad and the second bonding pad of the circuit board.

8. The lighting device of claim 7,
wherein regions of the third and fourth molding portions connected to each other extend to a region between the light source portion and the circuit board and cover the intermediate wire portions of the first and second connection members.

9. The lighting device of claim 7,
wherein the plurality of molding portions includes a central molding portion disposed on an intermediate connection portion between first and second end portions of the first and second connection members.

10. The lighting device of claim 2,
wherein the first and second connection members includes a first end portion connected to the first and second pads of the light source portion, a second end portion connected to the first and second bonding pads of the circuit board, respectively, and an intermediate wire portion between the first and second end portions,
wherein the plurality of molding portions includes a first molding portion covering the first end portion of the first connection member, the intermediate wire portion, and the second end portion, and a second molding portion covering the first end portion, the intermediate wire portion, and the second end portion of the second connection member.

11. The lighting device of claim 10, comprising:
a first connection portion connecting the first and second molding portions to each other on the light source portion.

12. The lighting device of claim 10, comprising:
a second connection portion connecting the first and second molding portions to each other on the circuit board.

13. The lighting device of any one of claims 1 to 5,
wherein the support plate includes a concave receiving portion to accommodate the circuit board.

14. The lighting device of any one of claims 1 to 5,
wherein each of the plurality of connection members is a ribbon wire whose width is more than twice its thickness.

15. A lamp comprising:
a lighting device that emits white light; and
a light guide module or reflector on the lighting device,
wherein the lighting device is a lamp according to any one of claims 1 to 5.
